(19) **Europäisches Patentamt**
**European Patent Office**
**Office européen des brevets**

(11) **EP 4 757 177 A1**

(12) **EUROPEAN PATENT APPLICATION**

(43) Date of publication:
**10.06.2026 Bulletin 2026/24**

(51) International Patent Classification (IPC):
*H03F 3/217* (2006.01)   *H03F 1/52* (2006.01)
*H03F 3/187* (2006.01)   *G01R 31/52* (2020.01)

(21) Application number: **25220823.6**

(22) Date of filing: **04.12.2025**

(52) Cooperative Patent Classification (CPC):
**H03F 3/2173; G01R 31/52; H03F 1/523;**
**H03F 3/187;** H03F 2200/03; H03F 2200/426;
H03F 2200/462; H03F 2200/78

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **06.12.2024 IT 202400027702**

(71) Applicant: **STMicroelectronics International N.V.**
**1228 Plan-les-Ouates, Geneva (CH)**

(72) Inventors:
• **GONANO, Giovanni**
  **I-20153 Milano (IT)**
• **BRAMBILLA, Davide Luigi**
  **I-20054 Segrate (Milano) (IT)**

(74) Representative: **Buzzi, Notaro & Antonielli d'Oulx**
**S.p.A.**
**Corso Vittorio Emanuele II, 6**
**10123 Torino (IT)**

(54) **CIRCUIT FOR DETECTING SHORT CIRCUITS IN FULL-BRIDGE CLASS-D AMPLIFIERS AND CORRESPONDING METHOD**

(57)     A circuit (35) for detecting electrical short circuits in a full-bridge class-D amplifier that comprises: a first branch (HP, LP) comprising a first high-side switch (HP) and a first low-side switch (LP); and a second branch (HM, LM) comprising a second high-side switch (HM) and a second low-side switch (LM). The circuit (35) comprising: a measuring unit configured to provide a first measure of a first operating characteristic of the high-side switch (HP; HM) comprised in one of the first branch (HP, LP) and the second branch (HM, LM) of the full-bridge class-D amplifier, and a second measure of a second operating characteristic of the low-side switch (LM; LP) comprised in the other of the first branch (HP, LP) and the second branch (HM, LM) of the full-bridge class-D amplifier; a checking unit configured to receive from the measuring unit the first measure and the second measure and to provide an unbalance signal indicative of the presence of unbalance between said first measure and said second measure; and a detection unit configured to receive from the checking unit said unbalance signal and to detect the presence of an electrical short circuit in response to said unbalance signal indicating the presence of unbalance between said first measure and said second measure.

FIG. 8

EP 4 757 177 A1

**Description**

Technical field

The description relates to circuits for detecting short circuits in full-bridge class-D amplifiers.

One or more embodiments can be related to circuits for detecting short circuits in full-bridge class-D amplifiers via unbalance checks.

Background

Known car radio class-D amplifiers comprise a full-bridge output stage, usually coupled with two LC filters, and a single supply, usually consisting in the car battery.

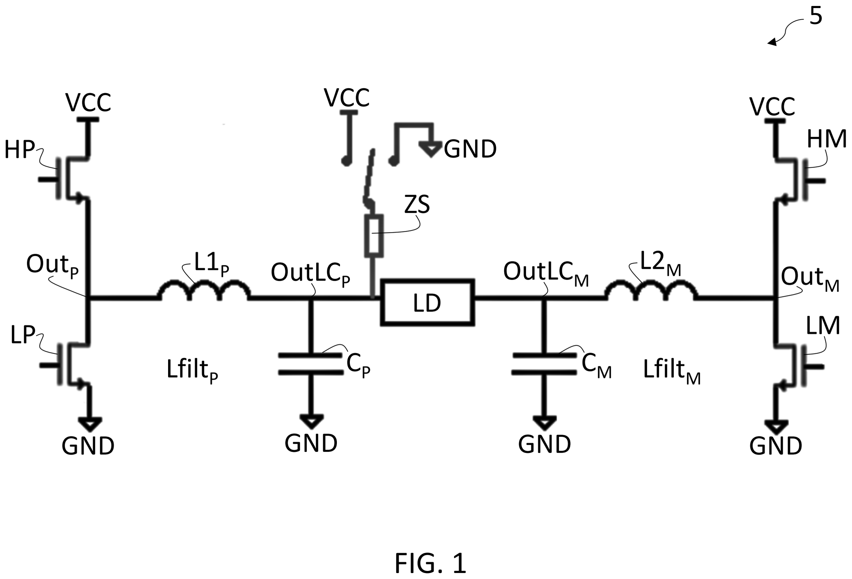

Figure 1 illustrates a known structure 5 of a full-bridge class-D output stage having a short circuit applied on the output.

The full-bridge output stage of the structure 5 illustrated in Figure 1 comprises:

  a first high-side switch HP, for instance, implemented via a first FET ("Field-Effect Transistor"), coupled between the supply, for instance, the car battery, configured to provide a voltage VCC and a first output node $Out_P$ of the output stage;

  a second high-side switch HM, for instance, implemented via a second FET, coupled between the supply, for instance, the car battery, configured to provide the voltage VCC and a second output node $Out_M$ of the output stage;

  a first low-side switch LP, for instance, implemented via a third FET, coupled between such first output node $Out_P$ of the output stage and a ground node GND; and

  a second low-side switch LM, for instance, implemented via a fourth FET, coupled between such second output node $Out_M$ of the output stage and the ground node GND.

Such output stage may be coupled with two LC filters, a first LC filter $Lfilt_P$ and a second LC filter $Lfilt_M$.

The first LC filter $Lfilt_P$ comprises:

  a first inductor $L1_P$ coupled between the first output node $Out_P$ of the output stage and a first output node of the LC filtering stage $OutLC_P$; and

  a first capacitor $C_P$ coupled between the first output node of the LC filtering stage $OutLC_P$ and the ground node GND.

The second LC filter $Lfilt_M$ comprises:

  a second inductor $L2_M$ coupled between the second output node $Out_M$ of the output stage and a second output node of the LC filtering stage $OutLC_M$; and

  a second capacitor $C_M$ coupled between the second output node of the LC filtering stage $OutLC_M$ and the ground node GND.

It is noted that a load LD may be coupled between the first output node of the LC filtering stage $OutLC_P$ and the second output node of the LC filtering stage $OutLC_M$.

The first high-side switch HP, the second high-side switch HM, the first low-side switch LP, and the second low-side switch LM may be implemented using both N-DMOS ("double-diffused MOS transistor" of N type), N or P-DMOS kind, GaN FETs ("Gallium Nitride FETs"), or any other available semiconductor technology.

The output of power audio amplifiers and other devices operating with PWM ("Pulse-Width Modulation") output stages, such as the full-bridge output stage illustrated in Figure 1, is to be protected against short circuits.

For instance, such short circuits may be due to connections of one of the output terminals (after the LC filters), for instance, either the first output node of the LC filtering stage $OutLC_P$ (as illustrated in Figure 1) or the second output node of the LC filtering stage $OutLC_M$, which are usually coupled to a load LD in normal driving conditions (that is, in absence of short circuit) to the ground node GND, to the supply configured to provide the voltage VCC, or to another output different from the load LD.

For example, such a connection may be performed:

  via an impedance ZS (such as a resistance) having a (even very) low value, for example, an impedance ZS in the order of few milli-ohm ("mΩ"); or

  via RL series, that is, a resistor-inductor circuit having a resistor R coupled in series with an impedance L.

Further short circuits may be due to connections of the first output node $Out_P$ or the second output node $Out_M$ (before the LC filters) to the ground node GND, to the supply configured to provide the voltage VCC, or to another output.

In such a case, a time related to the rising of the current flowing in the output stage may depend on the impedance ZS of the short circuit connection.

For example, such further short circuits may be present in filter-less applications (also used in audio systems), that is, in full-bridge output stage not coupled with LC filters, where the first output node $Out_P$ and the second output node $Out_M$ are directly driving the load LD.

The detection of such short circuits in full-bridge class-D amplifiers is usually made by comparing a sensing signal such as a sensed voltage proportional to an output current used to drive the load LD (such as a Vds voltage drop of one of the transistors or a voltage drop on a resistor comprised in the output stage) with a reference signal such as a reference voltage (for instance, obtained by injecting a reference current in an element matched with the considered transistor or the considered resistor).

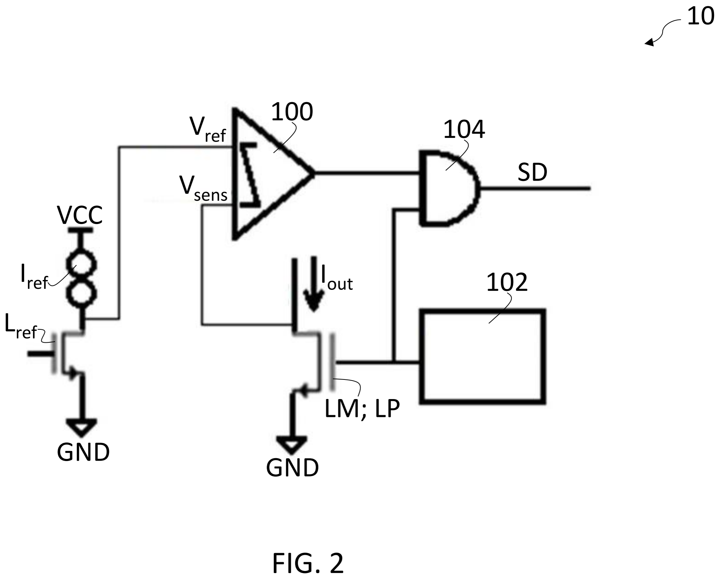

Figure 2 illustrates a known circuit 10 that detects output current overloads SD by sensing a Vds voltage, that is, the FET absolute voltage between a current-absorbing (drain) terminal and a current-supplying (source) terminal, of a low-side transistor LM or LP of the full-bridge class-D output stage.

Such sensed Vds voltage of the low-side transistor LM or LP of the full-bridge class-D output stage is the considered sensing signal $V_{sens}$ proportional to the output current $I_{out}$ used to drive the load LD.

Such low-side transistor LM or LP illustrated in Figure 2 is driven by a driver 102 via its control (gate) terminal and have the output current $I_{out}$ used to drive the load LD flowing between its current-absorbing (drain) terminal and its current-supplying (source) terminal.

The Vds voltage of the low-side transistor LM or LP of the full-bridge class-D output stage $V_{sens}$ is sensed by coupling the current-absorbing (drain) terminal of such low-side transistor LM or LP to a first input terminal of a comparator 100.

A second input terminal of the comparator 100 is configured to receive a reference voltage $V_{ref}$, for instance, corresponding to the Vds voltage of a reference transistor $L_{ref}$ (having a width value $W_{ref}$ and a channel length value $L_{min}$) matched with the low-side transistor LM or LP (having a width value $W_{main}$, for instance, usually 100 times bigger than the value $W_{ref}$, and the same channel length value $L_{min}$) and coupled between the supply at the voltage VCC and ground GND, such reference transistor $L_{ref}$ having an injected reference current $I_{ref}$ flowing between its current-absorbing (drain) terminal and its current-supplying (source) terminal.

It is noted that such reference current $I_{ref}$ corresponds to a maximum current allowed to flow in such reference transistor $L_{ref}$, and, since such reference transistor $L_{ref}$ is matched with the low-side transistor LM or LP, in the low-side transistor LM or LP.

Therefore, the reference voltage $V_{ref}$ is acting as a threshold corresponding to a maximum Vds voltage allowed in the reference transistor $L_{ref}$ and, again since such reference transistor $L_{ref}$ is matched with the low-side transistor LM or LP, in the low-side transistor LM or LP.

Hence, the comparator 100 is configured to:

receive the sensed Vds voltage $V_{sens}$ (at the first input terminal) and the reference voltage $V_{ref}$ (at the second input terminal),
compare such voltages in order to determine whether the sensed Vds voltage $V_{sens}$ is higher than the reference voltage $V_{ref}$ acting as threshold (that is, the maximum Vds voltage allowed), and
output a logic variable having, for instance, a high logic level when such sensed Vds voltage $V_{sens}$ is higher than the reference voltage $V_{ref}$ and a low logic level otherwise.

The logic variable is provided to a logic AND block 104 configured to receive such logic variable and a signal from the driver 102, for instance, having a high logic level if the driver 102 is driving the low-side transistor LM or LP to a conductive state and a low logic level otherwise.

Therefore, such logic AND block 104 is configured to detect a short circuit, for instance, by providing as output a short detection signal SD set to a high logic level, if the logic variable indicates that the sensed Vds voltage $V_{sens}$ is higher than the reference voltage $V_{ref}$ (that is, than the maximum Vds voltage allowed) and if the signal from the driver 102 indicates that such driver 102 is driving the low-side transistor LM or LP to a conductive state.

It is noted that the logic variable indicates that the sensed Vds voltage $V_{sens}$ is higher than the reference voltage $V_{ref}$ in response to the current provided as output by the full-bridge class-D amplifier $I_{out}$ being equal to a maximum current allowed to flow in such full-bridge class-D amplifier $I_{OCP}$.

The maximum current allowed to flow in such full-bridge class-D amplifier $I_{OCP}$ may be obtained using the following equation:

$$I_{OCP} = I_{ref} * \left(\frac{W_{main}}{W_{ref}}\right)$$

wherein $I_{ref}$ is the reference current described above, $W_{main}$ is the width value of the low-side transistor LM or LP, and $W_{ref}$ is the width value of the reference transistor $L_{ref}$.

In response to the logic AND block 104 detecting a short circuit, protective measures are enabled in order to prevent the full-bridge output stage to operate in non-safe operative conditions. For instance, the full-bridge output stage can be put in a 3-state condition or a cycle-by-cycle protection can be activated in order to reduce the current flowing in such output stage.

As an alternative to the Vds sensing described above, it is possible to sense the voltage drop on the source metallization of a transistor, for instance, a dmos transistor, comprised in the full-bridge class-D amplifier. In such a case, the voltage drop can be used as voltage signal for current sensing and current reference measurement.

A problem of traditional over-current protections ("OCP") such as the known solution of Figure 2 is that the output current $I_{out}$ used to drive the load LD provided by the full-bridge output stage has to reach the maximum current allowed (usually corresponding to maximum absolute ratings), that is, the reference current $I_{ref}$ described above, to detect short circuits conditions, therefore, the full-bridge class-D amplifier output stage is led to operate close to non-safe operative conditions.

Therefore, solutions according to Figure 2 have to react (very) quickly in order to prevent that the output current $I_{out}$ used to drive the load LD rises to dangerous values, leading the full-bridge output stage to operate in non-safe operative conditions.

It is noted that solutions according to Figure 2 are used in applications such as car radio amplifiers supplied with a battery, for instance, at about 14.4 V (volt), where the short circuit protection is required as a standard.

In case of systems having a higher supply voltage, for instance, up to about 48 V (volt), a standard for short circuit detection is not available and solutions according to Figure 2 may not enable the short circuit protection measures in time, that is, before the entering of the full-bridge output stage in a non-safe operative condition.

Usually, in such cases, some deviation from a fully compliant short circuit protection is accepted since the occurrence of a destructive event at the critical conditions (for instance, at high supply voltage, high temperature, or the like) might be judged low enough by the customer.

In fact, in applications such as car radio amplifiers supplied with the higher supply voltage, such testing comprises, for example, connecting one of the outputs of the full-bridge output stage to the supply at the voltage VCC or to ground GND along the whole supply voltage range (that is, for voltages comprised between zero and the considered higher supply voltage), at several driving conditions, considering different impedances, and at different temperatures.

Therefore, known solutions do not provide an acceptable tradeoff between maximum operative conditions and reliable short circuit protection in applications having higher supply voltages, that is, supply voltages higher than a battery voltage, for instance, supply voltages above 14.4V.

Hence, solutions to simplify the provision of a reliable short circuit protection even for supply voltages having high values, for instance, values above 14.4V (volt), would be beneficial in order to improve safety and prevent dangerous or faulty conditions.

Object and summary

An object of one or more embodiments is to contribute in providing such solutions that facilitate the provision of a reliable short circuit protection even for supply voltages having high values, for instance, values above 14.4V (volt), in order to improve safety and prevent dangerous or faulty conditions in full-bridge class-D amplifiers.

According to one or more embodiments, that object is achieved via a circuit for detecting short circuits in full-bridge class-D amplifiers having the features set forth in the claims that follow.

One or more embodiments concern a corresponding method.

The claims are an integral part of the technical teaching provided in respect of the embodiments.

Solutions as described herein address the previously described limitation via a circuit for detecting short circuits in full-bridge class-D amplifiers configured to:

check for the presence of unbalances between measures related to a high-side switch of a branch of the full-bridge and measures related to the low-side switch of the other branch of such full-bridge; and in response to the checking operation indicating the presence of an unbalance, detecting the presence of a short circuit.

Therefore, solutions as described herein relates to a circuit for detecting electrical short circuits in a full-bridge class-D amplifier.

The full-bridge class-D amplifier comprises:

a first branch comprising a first high-side switch configured to be coupled between a supply voltage and a first output node and a first low-side switch configured to be coupled between such first output node and ground; and a second branch comprising a second high-side switch configured to be coupled between such supply voltage and a second output node and a second low-side switch configured to be coupled between such second output node and ground.

The circuit according to solutions as described herein comprises:

a measuring unit configured to provide: a first measure of a first operating characteristic, for instance, a current, a voltage, or a time delay, of the high-side switch comprised in one of the first branch and the second branch of the full-bridge class-D amplifier; and a second measure of a second operating characteristic, for instance, a current, a voltage, or a time delay, of the low-side switch comprised in the other of the first branch and the second branch of the full-bridge class-D amplifier; a checking unit configured to receive from the measuring unit the first measure and the second measure and to provide an unbalance signal indicative of the presence of unbalance between such first measure and such second measure; and a detection unit configured to receive from the checking unit such unbalance signal and to detect the presence of an electrical short circuit in response to such unbalance signal indicating the presence of unbalance between such first measure and such second measure.

Solutions as described herein may be implemented via different approaches.

A first approach comprises detecting short circuit conditions based on current measurements.

In solutions according to such first approach, a current sensor is added for each of the four switches HP, LP, HM, and LM of the full-bridge.

A short circuit to the supply voltage or to ground can be detected when an unbalance between a current measured in a high-side switch of a branch of the full-bridge, that is, either HP or HM, and a current measured in the low-side switch of the other branch of the full-bridge, that is, either LM or LP respectively, is present.

The current sensors may be implemented in different ways.

For instance, a first way of implementing the current sensors comprises using a reference voltage as reference for a flash ADC and converting a sensed voltage proportional to the current flowing in a respective switch via such flash ADC. In such a case, an unbalance can be detected when the converted value for two different switches that are in a conductive state is above a threshold.

For instance, a second way of implementing such current sensors comprises level shifting to a common internal voltage or to ground and comparing sensed voltages proportional to currents flowing in respective switches that are in a conductive state. In such a case, an unbalance can be detected when the difference between the two sensed voltages is above a threshold.

A second approach comprises again detecting short circuit conditions based on current measurements.

In solutions according to such second approach, a current sensor is placed on the output of each of the two half-bridges.

In such a case, a short circuit to the supply voltage or to ground can be detected when an unbalance between the currents measured in the two half-bridges is present.

In solutions according to the second approach, the current sensors may be made by shunt resistors or by hall effects.

A further approach comprises detecting short circuit conditions based on time measurements.

Solutions according to such further approach comprise measuring at each PWM cycle (such PWM cycle being the cycle of a PWM - Pulse-Width Modulation - signal generated for driving the half-bridges comprised in the full-bridge via respective drivers configured to operate respective switches comprised in such half-bridges) the following current dependent time delays, corresponding to time laps between input signals provided to drivers coupled to respective half-bridges comprised in the full-bridge and PWM output signals provided by the branches (that are, half-bridges) of such full-bridge:

a first time delay indicative of a delay from a rising of an input signal provided to drivers related to a branch of the full-bridge (that is, to a half-bridge of the full-bridge) to a corresponding rising of the PWM output signal provided as output by such branch of the full-bridge, for instance, by a high-side switch of such branch;

a second time delay indicative of a delay from a falling of an input signal provided to the drivers related to such branch of the full-bridge (that is, to such half-bridge of the full-bridge) to a corresponding falling of the PWM output signal provided as output by such branch of the full-bridge, for instance, by the low-side switch of such branch;

a third time delay indicative of a delay from a rising of an input signal provided to drivers related to the other branch of the full-bridge (that is, to the other half-bridge of the full-bridge) to a corresponding rising of the PWM output signal provided as output by such other branch of the full-bridge, for instance, by a high-side switch of such other branch; and

a fourth time delay indicative of a delay from a falling of an input signal provided to the drivers related to such other branch of the full-bridge (that is, to such other half-bridge of the full-bridge) to a corresponding falling of the PWM output signal provided as output by such other branch of the full-bridge, for instance, by the low-side switch of such other branch.

In addition, solutions according to such further approach comprise detecting a short circuit to the supply voltage or to ground when an unbalance between the third time delay and the second time delay or the first time delay and the fourth time delay is present.

It is noted that in BD modulation the time delays may be stored in a capacitor by voltage conversion and then elaborated, while in AD modulation such time delays can be directly elaborated.

Hence, solutions as described herein facilitate providing reliable short circuit detection and protection features. For instance, solutions as described herein facilitate providing reliable short circuit detection also in the presence of supply voltages having high values, for instance, values above 14.4V (volt). Therefore, solutions as described herein may improve the trade-off between safety and performance (that is, maximum operative supply voltage and maximum load current) and may prevent dangerous or faulty conditions due to the presence of such short circuits in full-bridge class-D amplifiers.

Brief description of the figures

One or more embodiments will now be described, by way of example only, with reference to the annexed figures, wherein:

Figure 1 illustrates, as previously described, a known structure of a full-bridge class-D output stage having a short circuit applied on the output;
Figure 2 illustrates, as previously described, a known circuit that detects output current overloads by sensing the Vds voltage of a low-side transistor of the full-bridge class-D output stage;

Figure 3 illustrates a first exemplary circuit for detecting short circuits based on current sensing according to embodiments of the present description;

Figure 4 illustrates an exemplary current sensing block used in embodiments according to Figure 3 and configured to perform a conversion operation via an ADC ("Analog-to-Digital Converter") according to embodiments of the present description;

Figure 5 illustrates a further exemplary current sensing block used in embodiments according to Figure 3 and configured to perform a comparison operation via a comparator block according to embodiments of the present description;

Figure 6 illustrates a second exemplary circuit for detecting short circuits based on current sensing according to embodiments of the present description;

Figures 7A and 7B illustrate exemplary current sensing blocks used in embodiments according to Figure 6, according to embodiments of the present description;

Figure 8 illustrates an exemplary circuit for managing PWM ("Pulse-Width Modulation") signals used to drive a full-bridge class-D amplifier according to embodiments of the present description;

Figure 9 illustrates time delay behaviors as a function of an output current provided by the full-bridge class-D amplifier to a load coupled therewith, according to embodiments of the present description;

Figures 10A and 10B illustrate a full-bridge class-D amplifier having a short circuit to ground according to embodiments of the present description;

Figures 11A and 11B illustrate a full-bridge class-D amplifier having a short circuit to the supply voltage according to embodiments of the present description;

Figures 12A, 12B, and 12C illustrate behaviors of fronts of signals provided as output by the full-bridge class-D amplifier according to embodiments of the present description;

Figure 13 illustrates a third exemplary circuit for detecting short circuits based on time measurements in BD modulation conditions according to embodiments of the present description; and

Figure 14 illustrates a further exemplary circuit for detecting short circuits based on time measurements in AD modulation conditions according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As previously described, solutions as disclosed herein facilitate providing reliable short circuit detection and protection features even in presence of supply voltages having high values, for instance, values above 14.4V (volt), hence, improving the trade-off between safety and performance (that is, maximum operative supply voltage and maximum load current) and preventing dangerous or faulty conditions due to the presence of such short circuits.

Therefore, solutions as described herein aim at improving the robustness of full-bridge class-D amplifiers, for instance, used in car radio systems, to short circuits to the supply voltage VCC, to ground GND, or to a battery voltage (if different from the supply voltage VCC).

In addition, solutions as described herein can advantageously discriminate in a (even very) short time, for instance, in few periods of a PWM ("Pulse-Width Modulation") signal used to drive a full-bridge class-D amplifier, the presence of a short circuit to ground GND or to the supply voltage VCC with respect to the normal driving conditions, that is, to driving conditions without short circuits.

Such detection of the presence of a short circuit can be performed independently from the value of an output current $I_{out}$ provided by the full-bridge class-D amplifier to a load LD coupled therewith, that is, independently from the value of the output current $I_{out}$ with respect to a maximum current allowed to flow in the switches of the full-bridge.

Hence, the short circuit can be detected also in presence of output current $I_{out}$ values that are lower than the maximum current allowed to flow in transistors of the full-bridge class-D amplifier, such maximum current allowed to flow $I_{OCP}$ being obtained via the previously described equation, that is, by dividing the width value of a transistor comprised in the full-bridge class-D amplifier $W_{main}$ by the width value of the reference transistor $L_{ref}$ $W_{ref}$, obtaining the value $\frac{W_{main}}{W_{ref}}$, and by multiplying such value $\frac{W_{main}}{W_{ref}}$ by the value of the previously described reference current $I_{ref}$.

It is noted that such maximum current allowed to flow in transistors of the full-bridge class-D amplifier $I_{OCP}$ usually defines a threshold for enabling the over-current protections ("OCP"), thus, leaving more time for enabling such short circuit protection measures before the entering of the full-bridge output stage in non-safe operative conditions.

For instance, short circuits can be detected in presence of an output current $I_{out}$ value equal to or smaller than half the value of the maximum current allowed to flow in transistors of the full-bridge class-D amplifier.

It is noted that even if part of the description is focused on full-bridge class-D amplifiers used in audio applications, solutions as described herein can be applied to any full-bridge class-D amplifier where short circuits of the outputs to ground GND or to the supply voltage VCC have to be detected.

Solutions as described herein are related to a circuit for detecting short circuits in full-bridge class-D amplifiers based on the following operations:

a checking operation used for verifying the presence of unbalances between measures related to a high-side switch of a branch of the full-bridge, that is, either to the first high-side switch HP or the second high-side switch HM, and measures related to the low-side switch of the other branch of such full-bridge, that is, to the second low-side switch LM or the first low-side switch LP respectively; and
a detection operation that detects the presence of a short circuit to ground GND or to the supply voltage VCC (or battery voltage, if different) if the checking operation indicates that an unbalance between such measures is present.

Therefore, solutions as described herein refers to a circuit for detecting electrical short circuits, for instance, short circuit events to ground GND, to the supply voltage VCC, or to the battery voltage (if different from the supply voltage VCC), in a full-bridge class-D amplifier such as the full-bridge class-D amplifier 5 illustrated in Figure 1.

Therefore, such full-bridge class-D amplifier 5 comprises:

a first branch comprising a first high-side switch HP configured to be coupled between a supply voltage VCC and a first output node $Out_P$ and a first low-side switch LP configured to be coupled between such first output node $Out_P$ and ground GND; and
a second branch comprising a second high-side switch HM configured to be coupled between such supply voltage VCC and a second output node $Out_M$ and a second low-side switch LM configured to be coupled between such second output node $Out_M$ and ground GND.

The circuit according to solutions as described herein comprises:

a measuring unit configured to provide a first measure of a first operating characteristic (for instance, a current, a voltage, or a time measure) of the high-side switch (for instance, HP or HM) comprised in one of the first branch and the second branch of the full-bridge class-D amplifier 5, and a second measure of a second operating characteristic (for instance, again a current, a voltage, or a time measure) of the low-side switch (for instance, LM or LP respectively) comprised in the other of the first branch and the second branch of the full-bridge class-D amplifier 5;
a checking unit configured to receive from the measuring unit the first measure and the second measure and to provide an unbalance signal indicative of the presence of unbalance between such first measure and such second measure; and
a detection unit configured to receive from the checking unit such unbalance signal and to detect the presence of an electrical short circuit in response to such unbalance signal indicating the presence of unbalance between such first measure and such second measure.

As previously described, solutions as disclosed herein may be implemented via different approaches such as current based approaches or time-based approaches.

Therefore, the measures related to the high-side switch of a branch of the full-bridge and the measures related to the low-side switch of the other branch of such full-bridge may be measures of current.

The measures related to the high-side switch of a branch of the full-bridge are measures of the current flowing in such high-side switch, and the measures related to the low-side switch of the other branch of such full-bridge are measures of the current flowing in such low-side switch.

Alternatively, the measures related to the high-side switch of a branch of the full-bridge and the measures related to the low-side switch of the other branch of such full-bridge may be measures of time.

In such a case, the measures related to the high-side switch of a branch of the full-bridge are measures of a time delay measured:

from a rising edge of a driving signal provided to a driver configured to drive such high-side switch,
to a corresponding rising edge of an output signal provided by such high-side switch.

Similarly, measures related to the low-side switch of the other branch of such full-bridge are measures of a time delay measured:

from a falling edge of a driving signal provided to a driver configured to drive such low-side switch,
to a corresponding falling edge of an output signal provided by such low-side switch.

Therefore, in view of the above, solutions as described herein may refer to a first measure and a second measure which are current-based measures.

For instance, the first measure may be indicative of a current flowing in the high-side switch HP or HM comprised in one of the first branch and the second branch of the full-bridge class-D amplifier 5; and the second measure may be indicative of a current flowing in the low-side switch LM or LP respectively comprised in the other of the first branch and the second branch of the full-bridge class-D amplifier 5.

Similarly, solutions as described herein may refer to a first measure and a second measure which are time-based measures.

In such a case, the first branch and the second branch of the full-bridge class-D amplifier 5 can be driven via respective drivers 102 configured to receive respective driving signals, for instance, the first input signal $D_{INP}$ or the second input signal $D_{INM}$ described in the following description.

Therefore, for instance, the first measure may be indicative of a time delay (referred in the following description with the reference $T_{d\_r\_P}$ or $T_{d\_r\_M}$):

from a rising edge of a driving signal $D_{INP}$ or $D_{INM}$ provided to a driver $102_{HP}$ or $102_{HM}$ configured to drive said high-side switch HP or HM comprised in one of the first branch and the second branch of the full-bridge class-D amplifier 5
to a corresponding rising edge of an output signal, for instance, a signal provided via the first output node $Out_P$ or via the second output node $Out_M$, provided by said high-side switch HP or HM.

Similarly, for instance, the second measure may be indicative of a time delay (referred in the following description with the reference $T_{d\_f\_P}$ or $T_{d\_f\_M}$):

from a falling edge of a driving signal $D_{INP}$ or $D_{INM}$ provided to a driver $102_{LP}$ or $102_{LM}$ configured to drive said low-side switch LM or LP comprised in the other of the first branch and the second branch of the full-bridge class-D amplifier 5
to a corresponding falling edge of an output signal, for instance, a signal provided via the first output node $Out_P$ or via the second output node $Out_M$, provided by said low-side switch LM or LP.

A first approach comprises detecting short circuit conditions based on current measurements, for example, measurements of the currents provided as output by the output terminals of the full-bridge, that is, by the first output node $Out_P$ or the second output node $Out_M$.

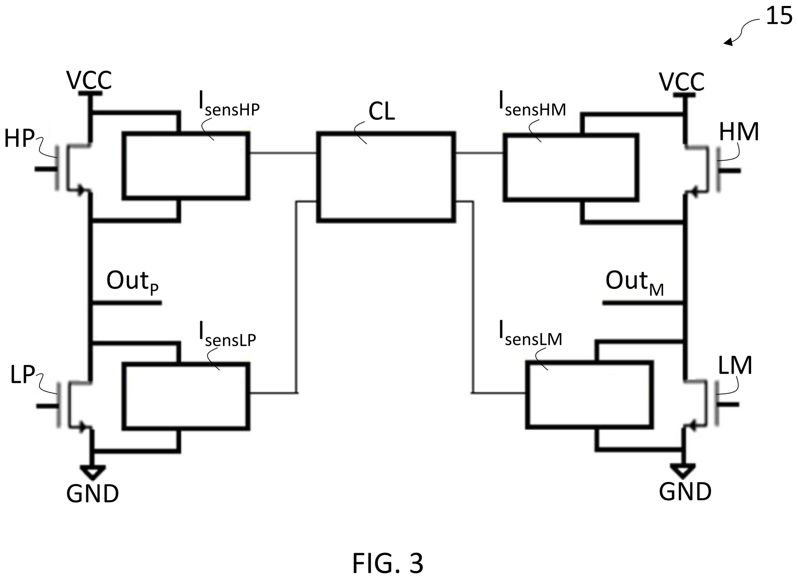

Such first approach is described by referring to the first exemplary circuit 15 illustrated in Figure 3, configured to detect short circuits, for instance, via a control logic CL, based on current sensing according to embodiments of the present description.

It is noted that, even if in Figure 3 and in the other figures the transistors comprised in the full-bridge are n-type MOSFET ("Metal-Oxide-Semiconductor Field-Effect Transistor"), also p-type MOSFET can be considered, and also different types of FETs such as N-DMOS ("double-diffused MOS transistor" of N type), N or P-DMOS kind, GaN FETs ("Gallium Nitride FETs"), or any other available semiconductor technology, can be considered.

In solutions according to such first approach, a current sensor $I_{sens}$ is added for each one of the four switches HP, LP, HM, and LM comprised in the full-bridge.

Hence, a first current sensor $I_{sensHP}$ may be configured to sense the current flowing in the first high-side switch HP and to send a signal indicative of such sensed current to a control logic unit CL.

To this purpose, such first current sensor $I_{sensHP}$ may have a first terminal coupled to a current-absorbing (drain) terminal of the first high-side switch HP and a second terminal coupled to a current-supplying (source) terminal of such first high-side switch HP.

Similarly, a second current sensor $I_{sensHM}$ may be configured to sense the current flowing in the second high-side switch HM and to send a signal indicative of such sensed current to the control logic unit CL.

To this purpose, such second current sensor $I_{sensHM}$ may have a first terminal coupled to a current-absorbing (drain) terminal of the second high-side switch HM and a second terminal coupled to a current-supplying (source) terminal of such second high-side switch HM.

A third current sensor $I_{sensLP}$ may be configured to sense the current flowing in the first low-side switch LP and to send a signal indicative of such sensed current to the control logic unit CL.

To this purpose, such third current sensor $I_{sensLP}$ may have a first terminal coupled to a current-absorbing (drain) terminal of the first low-side switch LP and a second terminal coupled to a current-supplying (source) terminal of such first low-side switch LP.

Similarly, a fourth current sensor $I_{sensLM}$ may be configured to sense the current flowing in the second low-side switch LM and to send a signal indicative of such sensed current to the control logic unit CL.

To this purpose, such fourth current sensor $I_{sensLM}$ may have a first terminal coupled to a current-absorbing (drain) terminal of the second low-side switch LM and a second terminal coupled to a current-supplying (source) terminal of such second low-side switch LM.

It is noted that each of such current sensors $I_{sens}$ may comprise an analog to digital (fast) converter used to convert the sensed analog currents flowing in respective switches into digital values indicative of such sensed analog currents to be sent to the control logic unit CL, for instance, via such signals indicative of the sensed currents.

The control logic unit CL may be configured to:

detect the presence of unbalances between a current sensed in a high-side switch of a branch of the full-bridge, that is, a current flowing in either the first high-side switch HP or the second high-side switch HM, and a current sensed in the low-side switch of the other branch of the full-bridge, that is, the current flowing in the second low-side switch LM or in the first low-side switch LP respectively; and

determine the presence of a short circuit to the supply voltage VCC (or to the battery voltage, if different) or to ground GND in response to such operation of detecting indicating the presence of an unbalance.

For instance, such unbalance may be detected if an absolute difference between the current sensed in a high-side switch of a branch of the full-bridge and the current sensed in the low-side switch of the other branch of the full-bridge, obtained either directly or via further conversions, is higher than a threshold.

In fact, the presence of a short circuit to the supply voltage VCC or to ground GND results in adding or subtracting current in one of the outputs of the full-bridge, that is, either to the first output node $Out_P$ or the second output node $Out_M$, thus, generating an unbalance between the currents that flow in a high-side switch and those that flow in a low-side switch of the full-bridge, such high-side switch and such low-side switch being simultaneously in a conductive state.

Therefore, in a standard modulation of the full-bridge, the unbalance is considered between a current flowing in the first high-side switch HP, sensed by the first current sensor $I_{sensHP}$, and the one flowing in the second low-side switch LM, sensed by the fourth current sensor $I_{sensLM}$, or between a current flowing in the second high-side switch HM, sensed by the second current sensor $I_{sensHM}$, and the one flowing in the first low-side switch LP, sensed by the third current sensor $I_{sensLP}$.

It is noted that such threshold may be set between $1/10^{th}$ and $2/10^{th}$ of a maximum rated output current that can be provided by a branch of the full-bridge, also considering a current ripple. In fact, the current flowing in each one of the switches during conduction can be obtained as the sum of a current flowing in the load LD and of a ripple current having a triangular wave shape.

Therefore, the checking unit described above, for instance, implemented via the control logic unit CL, of a circuit according to solutions as described herein may be configured to check for the presence of unbalance between such first measure and such second measure by:

determining an absolute value of a difference between such first measure and such second measure;

checking whether such absolute value of the difference is higher than a threshold, for instance, a current, a voltage, or a time threshold; and

determining the presence of unbalance if the checking operation indicates that such absolute value of the difference is higher than such threshold.

For instance, as illustrated in Figure 3, the measuring unit comprised in circuits according to solutions as described herein may comprise:

a first current sensor $I_{sensHP}$ coupled to the first high-side switch HP and configured to sense a current flowing therein,

a second current sensor $I_{sensHM}$ coupled to the second high-side switch HM and configured to sense a current flowing therein,

a third current sensor $I_{sensLP}$ coupled to the first low-side switch LP and configured to sense a current flowing therein, and

a fourth current sensor $I_{sensLM}$ coupled to the second low-side switch LM and configured to sense a current flowing therein.

In such a case, the first measure may be detected either via the first current sensor $I_{sensHP}$ or the second current sensor $I_{sensHM}$ and the second measure may be detected either via the fourth current sensor $I_{sensLM}$ or the third current sensor $I_{sensLP}$, respectively.

The first current sensor $I_{sensHP}$, the second current sensor $I_{sensHM}$, the third current sensor $I_{sensLP}$, and the fourth current sensor $I_{sensLM}$ may be implemented in different ways.

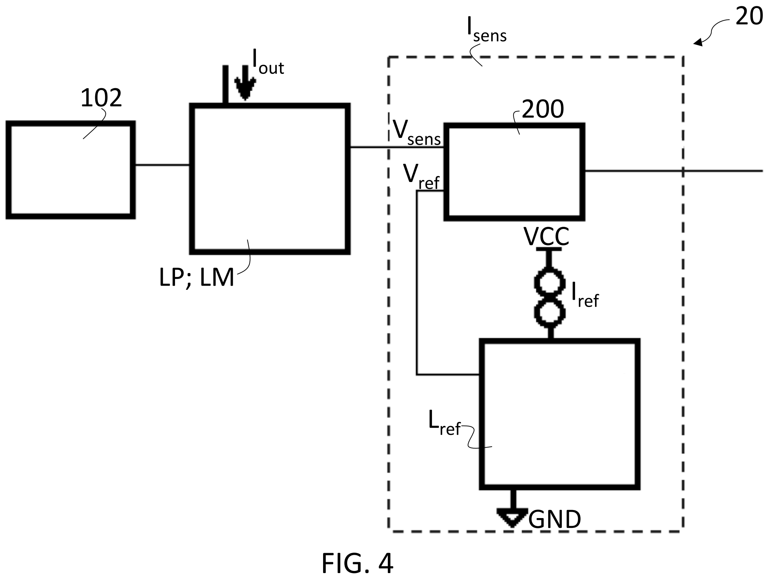

For instance, a first way of implementing the current sensors is illustrated in Figure 4 and comprises:

using a reference voltage $V_{ref}$ as reference for a flash ADC 200, and

converting a sensed voltage $V_{sens}$ proportional to the

current flowing in a respective switch $I_{out}$ via such flash ADC 200.

If current sensors according to Figure 4 are considered, an unbalance can be detected when an absolute value of the difference between the converted value of two different switches that are in a conductive state, that is, for a high-side switch of a branch of the full-bridge and the low-side switch of the other branch of the full-bridge, is above a threshold.

Therefore, Figure 4 illustrates 20 an exemplary current sensing block $I_{sens}$ used in embodiments according to Figure 3 and configured to perform a conversion operation via an ADC ("Analog-to-Digital Converter") 200 according to embodiments of the present description.

The current sensing block $I_{sens}$, that is, a current sensor according to Figure 4, may comprise a reference sensing element $L_{ref}$, for instance, a reference transistor, matched with the respective switch coupled to such current sensing block $I_{sens}$, that is, either the first high-side switch HP, the second high-side switch HM, the first low-side switch LP, or the second low-side switch LM.

For instance, Figure 4 illustrates a reference sensing element $L_{ref}$ matching either the first low-side switch LP or the second low-side switch LM, since such reference sensing element $L_{ref}$ is referred to ground GND and have injected therein a reference current $I_{ref}$ flowing between its current-absorbing (drain) terminal and its current-supplying (source) terminal.

The reference current $I_{ref}$ corresponds again to a maximum current allowed to flow $I_{OCP}$ in transistors of the full-bridge class-D amplifiers, such a maximum current allowed to flow in such transistors $I_{OCP}$ being obtained according to the equation described above, since such reference sensing element $L_{ref}$ is matched with the respective switch HP, HM, LP or LM.

The current sensing block $I_{sens}$ may be configured to receive a sensed voltage $V_{sens}$ proportional to the current $I_{out}$ provided as output by one of the output terminals of the full-bridge, that is, either to the first output node $Out_P$ or the second output node $Out_M$, and flowing in a respective switch, that is, either the first high-side switch HP, the second high-side switch HM, the first low-side switch LP, or the second low-side switch LM, driven via a respective driver 102.

It is underlined again that the exemplary current sensing block $I_{sens}$ of Figure 4 is configured to be coupled to either the first low-side switch LP or the second low-side switch LM. A structure for the first high-side switch HP and the second high-side switch HM may be obtained by using a reference sensing element $L_{ref}$ matched to such high-side switches.

A flash ADC 200 comprised in the current sensing block $I_{sens}$ is configured to receive such sensed voltage $V_{sens}$ and a reference voltage $V_{ref}$ sensed from the reference sensing element $L_{ref}$, and to convert such sensed voltage $V_{sens}$ into a digital value based on the sensed reference voltage $V_{ref}$ which is used as reference voltage of the flash ADC 200.

The digital value obtained by the flash ADC 200 is provided to the control logic unit CL, which is configured to detect the presence of unbalances if a digital value received from a current sensor $I_{sens}$ coupled to a high-side switch of a branch of the full-bridge and a digital value received from a current sensor $I_{sens}$ coupled to the low-side switch of the other branch of the full-bridge differs for more than a given number of ADC levels, for instance, more than 2 ADC levels, from each other.

It is noted that a resolution of a flash ADC 200 used in current sensors $I_{sens}$ according to Figure 4 may also be low, for instance, may comprise 8 levels. In addition, a conversion time of such flash ADC 200 used in current sensors $I_{sens}$ according to Figure 4 may be in the range of about 1/4 of the PWM signal period or less.

Therefore, the current sensors $I_{sensHP}$, $I_{sensHM}$, $I_{sensLP}$, and $I_{sensLM}$ according to solutions as described herein may comprise a, preferably flash, Analog-to-Digital Converter, ADC, 200.

Such Analog-to-Digital Converter, ADC, 200 may be configured:

> to sense a voltage $V_{sens}$ proportional to the current flowing in a respective switch, that is, either HP, HM, LP, or LM, coupled to a considered current sensor, that is, either the current sensor $I_{sensHP}$, $I_{sensHM}$, $I_{sensLP}$, or $I_{sensLM}$ respectively;
> to sense a reference voltage $V_{ref}$ proportional to a maximum acceptable current, for instance, the previously described reference current $I_{ref}$, flowing in a reference switch, for instance, the previously described reference transistor $L_{ref}$, matched with said respective switch; and
> to convert said sensed voltage $V_{sens}$ in a digital value based on said sensed reference voltage $V_{ref}$, such digital value being the first measure or the second measure described above.

It is noted that, since only two switches, that is, HP and LM or HM and LP, of the four switches comprised in the full-bridge can be simultaneously conductive, it is possible to consider only two flash ADC 200, multiplexing their inputs.

Hence, a high-side current sensor may be coupled, for instance, via a multiplexing unit, either to the first high-side switch HP or the second high-side switch HM in order to detect a current flowing in the high-side of the full-bridge.

Similarly, a low-side current sensor may be coupled, for instance, again via a multiplexing unit, either to the first low-side switch LP or the second low-side switch LM in order to detect a current flowing in the low-side of the full-bridge.

Therefore, the measuring unit of circuits according to solutions as described herein may comprise:

> a high-side current sensor configured to be coupled either to the first high-side switch HP or the second high-side switch HM and to sense a current flowing in the coupled high-side switch HP or HM, and

a low-side current sensor configured to be coupled either to the second low-side switch LM or the first low-side switch LP respectively, and to sense a current flowing in the coupled low-side switch LM or LP.

In such a case, the first measure may be detected via the high-side current sensor and the second measure may be detected via the low-side current sensor.

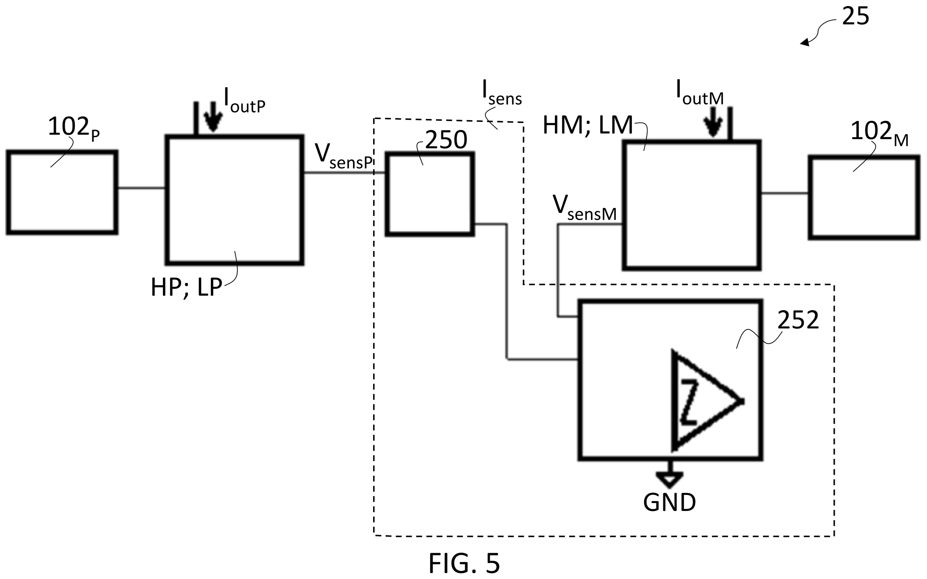

For example, a second way of implementing the current sensors is illustrated in Figure 5 and comprises:

level shifting to a common internal voltage or to ground GND sensed voltages $V_{sensP}$ and $V_{sensM}$ proportional to currents flowing in respective switches $I_{outP}$ and $I_{outM}$ that are in a conductive state, and

comparing, obtaining a difference, the level-shifted sensed voltages $V_{sensP}$ and $V_{sensM}$.

If current sensors according to Figure 5 are considered, an unbalance can be detected when the difference between the two level-shifted sensed voltages $V_{sensP}$ and $V_{sensM}$ is above a threshold.

Therefore, Figure 5 illustrates 25 a further exemplary current sensing block $I_{sens}$ used in embodiments according to Figure 3 and configured to perform a comparison operation via a comparator block 252 according to embodiments of the present description.

The current sensing block $I_{sens}$, that is, a current sensor according to Figure 5, may comprise a comparator block 252 coupled to ground GND and a level shifter 250.

The level shifter 250 is configured to:

receive a first sensed voltage $V_{sensP}$ proportional to a first current $I_{outP}$ provided as output by the output terminal of a branch of the full-bridge, for instance, the first output node $Out_P$, and flowing in a respective switch of such branch, for instance, either the first high-side switch HP or the first low-side switch LP, driven via a respective first driver $102_P$; and

level shift such received first sensed voltage $V_{sensP}$ to a common internal voltage, for instance, from high-side to low-side if the first sensed voltage $V_{sensP}$ is sensed from the first high-side switch HP and from low-side to high-side if the first sensed voltage $V_{sensP}$ is sensed from the first low-side switch LP.

In solutions according to the present description, the current sensing block $I_{sens}$ may comprise an additional level shifter, such level shifter being configured to receive a second sensed voltage $V_{sensM}$ proportional to a second current $I_{outM}$ provided as output by the output terminal of the other branch of the full-bridge, for instance, the second output node $Out_M$, and flowing in a respective switch of such other branch, for instance, either the second high-side switch HM or the second low-side switch LM, driven via a respective second driver $102_M$.

If such additional level shifter is present, the first sensed voltage $V_{sensP}$ and the second sensed voltage $V_{sensM}$ may be level shifted to any common internal voltage or to ground GND.

The comparator block 252, coupled to ground GND, is configured to:

receive a first level-shifted voltage provided as output by the level shifter 250 and the second sensed voltage $V_{sensM}$ (or a second level-shifted voltage provided as output by the additional level shifter, if present); and

compare such first level-shifted voltage and such second sensed voltage $V_{sensM}$ (or the second level-shifted voltage, if the additional level shifter is present), obtaining an (absolute) voltage difference.

Therefore, as described above, an unbalance can be detected when the (absolute) voltage difference provided by the comparator block 252 is above a threshold.

It is noted that if current sensors according to Figure 5 are considered, a reference voltage $V_{ref}$ is not requested, but the first high-side switch HP and the second low-side switch LM or the first low-side switch LP and the second high-side switch HM are matched both thermally and versus process spread.

Therefore, the measuring unit comprised in circuits according to solutions as described herein may comprise a level-shifter 250 configured:

to sense one voltage out of a voltage $V_{sensP}$ proportional to the current flowing in the high-side switch HP or HM comprised in one of the first branch and the second branch of the full-bridge class-D amplifier 5 and a voltage $V_{sensM}$ proportional to the current flowing in the low-side switch LM or LP respectively comprised in the other of the first branch and the second branch of the full-bridge class-D amplifier 5, to level-shift such sensed voltage $V_{sensP}$ or $V_{sensM}$ to a voltage level of the other voltage ($V_{sensM}$ or $V_{sensP}$ respectively) out of the voltage $V_{sensP}$ proportional to the current flowing in the high-side switch HP or HM comprised in one of the first branch and the second branch of the full-bridge class-D amplifier 5 and the voltage $V_{sensM}$ proportional to the current flowing in the low-side switch LM or LP respectively comprised in the other of the first branch and the second branch of the full-bridge class-D amplifier 5, to provide such level-shifted sensed voltage as the first measure described above in response to the sensed voltage being the voltage $V_{sensP}$ proportional to the current flowing in the high-side switch HP or HM comprised in one of the first branch and the second branch of the full-bridge class-D amplifier 5, the voltage $V_{sensM}$ proportional to the current flowing in the low-side switch LM or LP comprised in the other of the first branch and the second branch of the full-bridge class-D amplifier 5 being provided as the second measure described above, and

to provide the voltage $V_{sensP}$ proportional to the current flowing in the high-side switch HP or HM comprised in one of the first branch and the second branch of the full-bridge class-D amplifier 5 as the first measure described above in response to the sensed voltage being the voltage $V_{sensM}$ proportional to the current flowing in the low-side switch LM or LP comprised in the other of the first branch and the second branch of the full-bridge class-D amplifier 5, such level-shifted sensed voltage being provided as the second measure described above.

Alternatively, the measuring unit comprised in circuits according to solutions as described herein may comprise:

a first level-shifter configured:

to sense a voltage $V_{sensP}$ proportional to the current flowing in such high-side switch HP or HM comprised in one of the first branch and the second branch of the full-bridge class-D amplifier 5,
to level-shift such sensed voltage $V_{sensP}$ to a voltage level, for instance, to ground GND or to any other voltage level, and
to provide such level-shifted sensed voltage as the first measure described above; and
a second level-shifter configured:

to sense a voltage $V_{sensM}$ proportional to the current flowing in such low-side switch LM or LP respectively comprised in the other of the first branch and the second branch of the full-bridge class-D amplifier 5,
to level-shift such sensed voltage $V_{sensM}$ to such voltage level, for instance, to ground GNS or to such any other voltage level, and
to provide such level-shifted sensed voltage as the second measure described above.

A second approach comprises again detecting short circuit conditions based on current measurements, for example, measurements of the currents provided as output by the output terminals of the full-bridge $I_{outP}$ and $I_{outM}$, that is, by either the first output node $Out_P$ or the second output node $Out_M$.

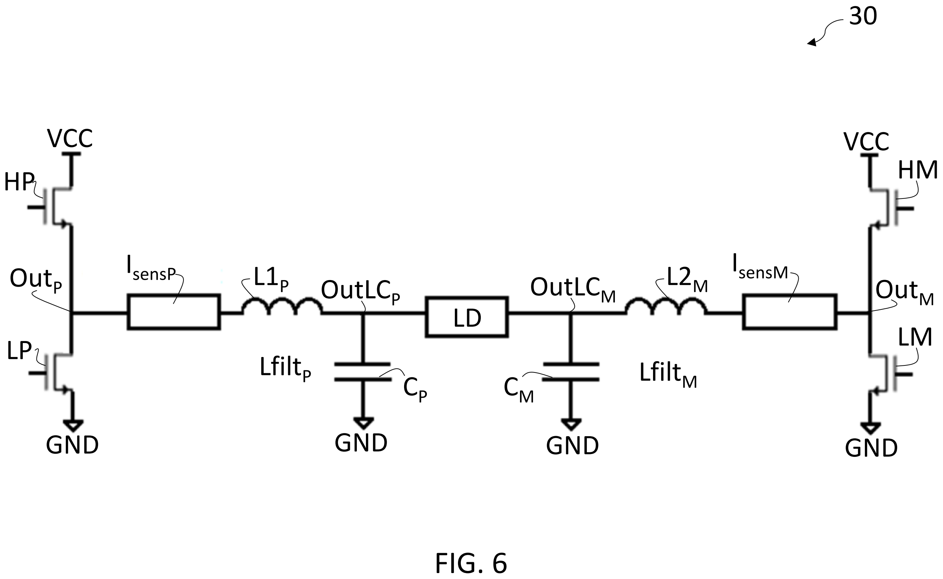

Such second approach is described by referring to the second exemplary circuit 30 illustrated in Figure 6, configured to detect short circuits based on current sensing according to embodiments of the present description.

It is noted that parts, elements, and/or components which have already been described with reference to Figure 1 are denoted by the same references previously used in such figure. Therefore, the description of such previously described parts, elements, and/or components will not be repeated in the following in order not to overburden the present description.

In solutions according to such second approach, a current sensor $I_{sens}$ is placed on the output of each of the two half-bridges of the full-bridge, that is, on each of its branches.

In such a case, a short circuit to the supply voltage VCC or to ground GND can be detected when an unbalance between the currents measured in the two half-bridges is present.

Such unbalance may be determined, for instance, if an absolute value of a difference between a current $I_{outP}$ sensed by a first current sensor $I_{sensP}$ placed on a branch of the full-bridge (for instance, coupled between the first output node $Out_P$ and the first inductor $L1_P$, if present) and a current $I_{outM}$ sensed by a second current sensor $I_{sensM}$ placed on the other branch of the full-bridge (for instance, coupled between the second output node $Out_M$ and the second inductor $L2_M$, if present) is above a threshold. It is noted that such difference may be obtained either via an analog comparator or via a digital conversion, preferably by considering margins due to eventual differential ripple presence.

Otherwise, such unbalance may be determined by:

comparing a current $I_{outP}$ sensed by a first current sensor $I_{sensP}$ placed on a branch of the full-bridge with ground GND or with any internal supply, obtaining a first single ended comparison;
comparing a current $I_{outM}$ sensed by a second current sensor $I_{sensM}$ placed on the other branch of the full-bridge with ground GND or with the internal supply, obtaining a second single ended comparison; and
determining if an absolute value of a difference between the first single ended comparison and the second single ended comparison is higher than a threshold, for instance, via an analog comparator or via a digital conversion, preferably by considering margins due to eventual differential ripple presence.

Therefore, the measuring unit comprised in circuits according to solutions as described herein may comprise:

a first branch current sensor, for instance, the first current sensor $I_{sensP}$, coupled to the first output node $Out_P$ (for instance, between the first output node $Out_P$ and the first inductor $L1_P$ or the load LD) and configured to sense a current $I_{outP}$ flowing therein, and
a second branch current sensor, for instance, a second current sensor $I_{sensM}$, coupled to the second output node $Out_M$ (for instance, between the second output node $Out_M$ and the second inductor $L2_M$ or the load LD) and configured to sense a current $I_{outM}$ flowing therein.

In such a case, the first measure described above may be detected via one current sensor out of the first branch current sensor $I_{sensP}$ and the second branch current sensor $I_{seasM}$ and the second measure described above may be detected via the other current sensor out of the first branch current sensor $I_{sensP}$ and the second branch current sensor $I_{seasM}$.

In solutions according to the second approach, the current sensors may be implemented via shunt resistors (usually being a MOS parasitic metal resistance), metal sensing, or hall effects.

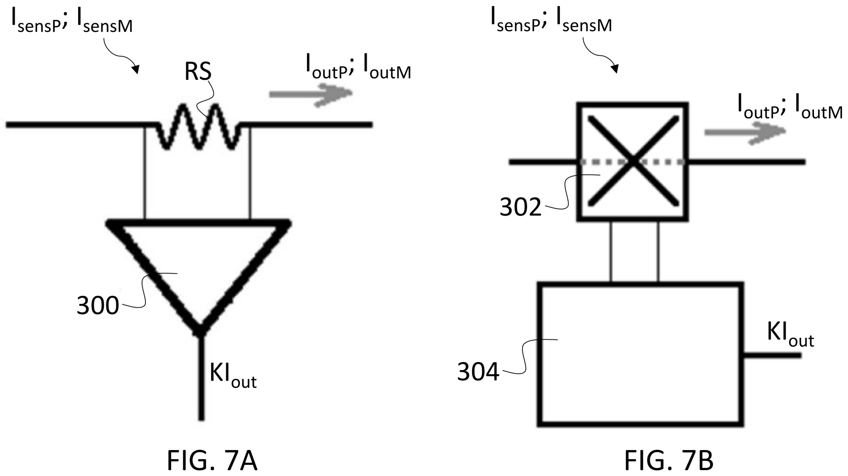

Such implementations are illustrated in Figures 7A and 7B, which show exemplary current sensing blocks $I_{sensP}$ and $I_{sensM}$ used in embodiments according to Figure 6 of the present description.

Figure 7A illustrates a parasitic or shunt resistor RS into which flows the current provided as output by one of the output terminals of the full-bridge $I_{outP}$ or $I_{outM}$.

Such current $I_{outP}$ or $I_{outM}$ can be sensed via a comparator 300 having a first input terminal coupled to a first terminal of the parasitic or shunt resistor RS and a second input terminal coupled to a second terminal of the parasitic or shunt resistor RS, such comparator 300 being configured to provide as output a current $KI_{out}$ proportional to the current $I_{outP}$ or $I_{outM}$ that flows in the parasitic or shunt resistor RS.

It is noted that such comparator 300 advantageously be a fully differential amplifier with a high CMRR ("Common-Mode Rejection Ratio").

Figure 7B illustrates a hall sensor 302 into which flows the current provided as output by one of the output terminals of the full-bridge $I_{outP}$ or $I_{outM}$.

Such hall sensor 302 is coupled to an analog front-end 304 configured to provide as output a current $KI_{out}$ proportional to the current $I_{outP}$ or $I_{outM}$ that flows in the hall sensor 302.

It is noted that such hall sensor 302 advantageously comprise temperature compensation and offset canceling and amplification features.

Therefore, the first branch current sensor $I_{sensP}$ and the second branch current sensor $I_{sensM}$ described above may be implemented via shunt resistors, preferably by MOS parasitic metal resistance, metal sensing, or hall effect sensing.

Solutions according to the second approach can be advantageously used in class-D amplifiers without integrated current sensors.

In fact, when a full-bridge class-D amplifier is not equipped with internal (integrated) current sensing elements, current sensors according to such second approach can be applied externally (for instance, at PCB - Printed Circuit Board - level), by placing such current sensors:

between the output terminals of the full-bridge (PWM outputs) and the LC filters; or

between the LC filters and the load LD.

In such a case, a signal circuity external to the full-bridge class-D amplifier can be used for performing conditioning operations, analog to digital conversions, and comparison operations.

It is noted that both with the first approach and with the second approach it is possible to detect short circuits before the reaching of the maximum current allowed to flow in the switches of the full-bridge, thus, before that the full-bridge output stage is brought to operate close to non-safe operative conditions, detecting short circuits faster than known solutions.

A further approach comprises detecting short circuit conditions based on time measurements.

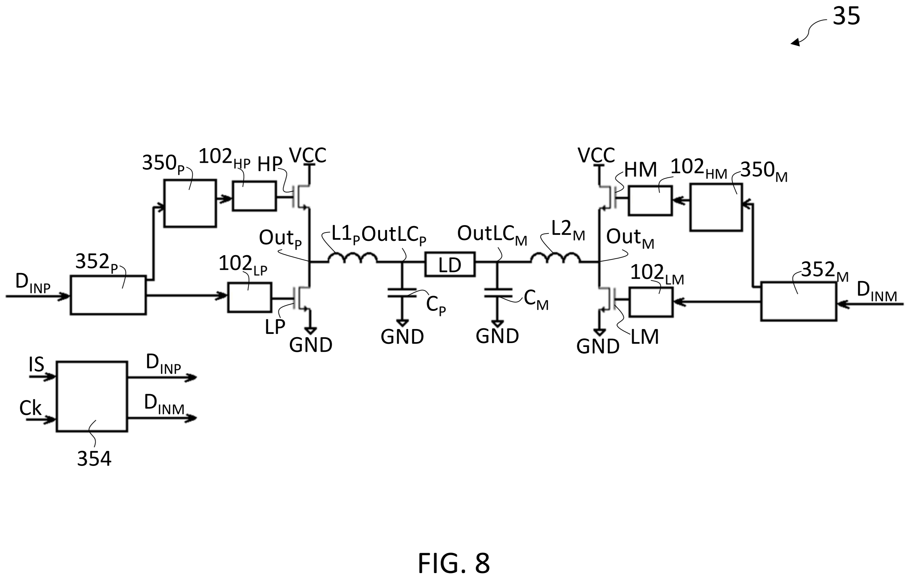

To describe such further approach, an exemplary circuit 35 for managing PWM ("Pulse-Width Modulation") signals $D_{INP}$ and $D_{INM}$ used to drive a full-bridge class-D amplifier is illustrated in Figure 8 according to embodiments of the present description.

It is noted that parts, elements, and/or components which have already been described with reference to Figure 1 are denoted by the same references previously used in such figure. Therefore, the description of such previously described parts, elements, and/or components will not be repeated in the following in order not to overburden the present description.

Each of the switches comprised in the full-bridge class-D amplifier may be driven by a respective driver 102.

Therefore, the first high-side switch HP may be driven by a first high-side driver $102_{HP}$ coupled to a first low-side to high-side level shifter $350_P$, such first high-side driver $102_{HP}$ being configured to receive a first level-shifted control signal from such first low-side to high-side level shifter $350_P$ and to drive the first high-side switch HP based on such received first level-shifted control signal.

The first low-side to high-side level shifter $350_P$ may be configured to receive a first control signal from a first dead time conditioning block $352_P$, to level-shift such received first control signal, obtaining the first level-shifted control signal, and to provide such first level-shifted control signal to the first high-side driver $102_{HP}$.

The first dead time conditioning block $352_P$ may be configured to receive a first input signal $D_{INP}$, for instance, a PWM signal, that is to be provided to either a high-side driver or a low-side driver, and to generate, based on whether such received first input signal $D_{INP}$ is to be provided to the high-side driver or the low-side driver, a first control signal to be provided to the first low-side to high-side level shifter $350_P$ and a second control signal to be provided to a first low-side driver $102_{LP}$.

The first low-side switch LP may be driven by such first low-side driver $102_{LP}$ coupled to the first dead time conditioning block $352_P$, such first low-side driver $102_{LP}$ being configured to receive the second control signal from such first dead time conditioning block $352_P$ and to drive the first low-side switch LP based on such received second control signal.

Similarly, the second high-side switch HM may be driven by a second high-side driver $102_{HM}$ coupled to a second low-side to high-side level shifter $350_M$, such second high-side driver $102_{HM}$ being configured to receive a second level-shifted control signal from such second low-side to high-side level shifter $350_M$ and to drive the second high-side switch HM based on such received second level-shifted control signal.

The second low-side to high-side level shifter $350_M$ may be configured to receive a further first control signal from a second dead time conditioning block $352_M$, to level-shift such received further first control signal, obtaining the second level-shifted control signal, and to provide such second level-shifted control signal to the second high-side driver $102_{HM}$.

The second dead time conditioning block $352_M$ may be configured to receive a second input signal $D_{INM}$, for instance, a PWM signal, that is to be provided to either a high-side driver or a low-side driver, and to generate, based on whether such received second input signal $D_{INM}$ is to be provided to the high-side driver or the low-side driver, a further first control signal to be provided to the second low-side to high-side level shifter $350_M$ and a further second control signal to be provided to a second low-side driver $102_{LM}$.

The second low-side switch LM may be driven by such second low-side driver $102_{LM}$ coupled to the second dead time conditioning block $352_M$, such second low-side driver $102_{LM}$ being configured to receive the further second control signal from such second dead time conditioning block $352_M$ and to drive the second low-side switch LM based on such received further second control signal.

The first input signal $D_{INP}$ that is to be provided to either the first high-side driver $102_{HP}$ or the first low-side driver $102_{LP}$, for instance, a PWM signal, and the second input signal $D_{INM}$ that is to be provided to either the second high-side driver $102_{HM}$ or the second low-side driver $102_{LM}$, for instance, again a PWM signal, may be generated by a PWM modulation block 354 based on a reference input signal IS and on a clock Ck.

In view of the above, it is possible to define a PWM cycle as the cycle of a PWM ("Pulse-Width Modulation") signal generated for driving the half-bridges comprised in the full-bridge via a driver 102 in order to operate the pair of switches HP and LP or HM and LM comprised therein, such PWM signal being either the first input signal $D_{INP}$ or the second input signal $D_{INM}$.

Thus, solutions according to such further approach comprise measuring at each PWM cycle current dependent time delays corresponding to time laps between rising edges or falling edges of the input signals $D_{INP}$ and $D_{INM}$ that are to be provided to the drivers 102 coupled to respective switches of the half-bridges comprised in the full-bridge and PWM signals provided as output by the branches (that are, half-bridges) of such full-bridge, that is, PWM signals measurable on the first output node $Out_P$ or on the second output node $Out_M$.

Such measured current dependent time delays comprise a first time delay $T_{d\_r\_P}$, a second time delay $T_{d\_f\_P}$, a third time delay $T_{d\_r\_M}$, and a fourth time delay $T_{d\_f\_M}$.

The first time delay $T_{d\_r\_P}$ corresponds to a delay from a rising of the first input signal $D_{INP}$ that is to be provided to the first high-side driver $102_{HP}$ or to the first low-side driver $102_{LP}$ to a corresponding rising of a PWM signal provided as output by the first high-side switch HP via the first output node $Out_P$.

The second time delay $T_{d\_f\_P}$ corresponds to a delay from a falling of the first input signal $D_{INP}$ that is to be provided to the first high-side driver $102_{HP}$ or to the first low-side driver $102_{LP}$ to a corresponding falling of the PWM signal provided as output by the first low-side switch LP via the first output node $Out_P$.

The third time delay $T_{d\_r\_M}$ corresponds to a delay from a rising of the second input signal $D_{INM}$ that is to be provided to the second high-side driver $102_{HM}$ or to the second low-side driver $102_{LM}$ to a corresponding rising of the PWM signal provided as output by the second high-side switch HM via the second output node $Out_M$.

The fourth time delay $T_{d\_f\_M}$ corresponds to a delay from a falling of the second input signal $D_{INM}$ that is to be provided to the second high-side driver $102_{HM}$ or to the second low-side driver $102_{LM}$ to a corresponding falling of the PWM signal provided as output by the second low-side switch LM via the second output node $Out_M$.

In addition, solutions according to such further approach comprise detecting a short circuit to the supply voltage VCC or to ground GND when an unbalance between the third time delay $T_{d\_r\_M}$ and the second time delay $T_{d\_f\_P}$ or the first time delay $T_{d\_r\_P}$ and the fourth time delay $T_{d\_f\_M}$ is present, that is, when an unbalance between time delays related to a high-side switch HP or HM of a branch and time delays related to the low-side switch LM or LP respectively of the other branch is present.

For instance, such unbalance may be detected when an absolute value of a difference between such third time delay $T_{d\_r\_M}$ and such second time delay $T_{d\_f\_P}$ or such first time delay $T_{d\_r\_P}$ and such fourth time delay $T_{d\_f\_M}$ is above a time threshold.

It is noted that in BD modulation the time delays may be stored in a capacitor by voltage conversion and then elaborated, while in AD modulation (usually referred to as Out of Phase modulation) such time delays can be directly elaborated, for instance, by measuring signal (rising and/or falling) front delays between fronts of the PWM signals provided as output by the first output node $Out_P$ and the second output node $Out_M$ and by checking if such measured signal front delays exceeds the threshold.

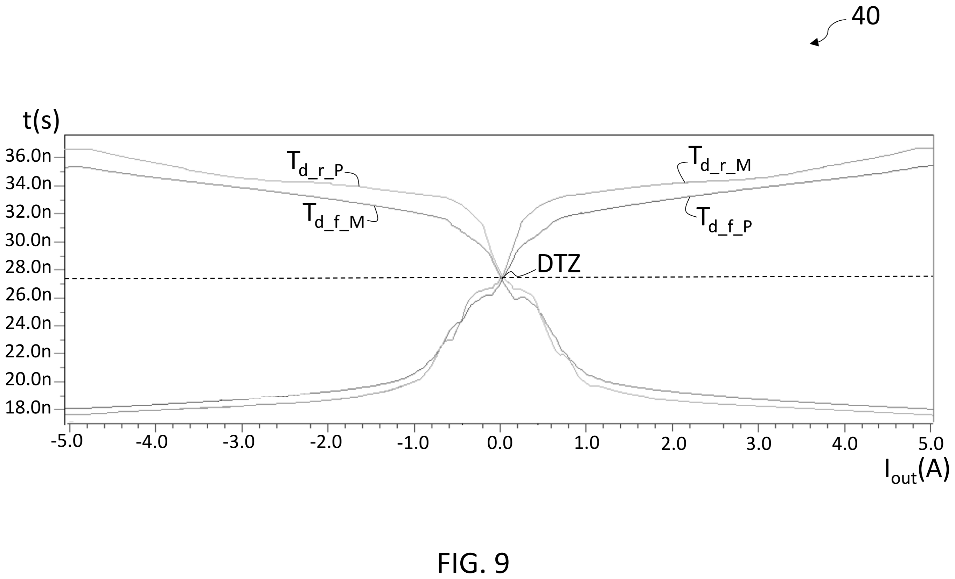

Figure 9 illustrates behaviors 40 of the previously described time delays $T_{d\_r\_M}$, $T_{d\_f\_P}$, $T_{d\_r\_P}$, and $T_{d\_f\_M}$ as a function of the output current $I_{out}$ provided by the full-bridge class-D amplifier to a load LD coupled therewith, according to embodiments of the present description.

It is noted that values and scales reported in Figure 9 in the time axis t, expressed in seconds (s), and the current axis $I_{out}$, expressed in ampere (A), are only reported therein by way of example, thus, different values and scales may also be considered without affecting the behaviors 40 and the related conclusions described in the following. In fact, such values and scales may change based on the technology that is used to implement the switches of the full-bridge.

In addition to such previously described time delays $T_{d\_r\_M}$, $T_{d\_f\_P}$, $T_{d\_r\_P}$, and $T_{d\_f\_M}$, it is possible to define a dead time delay DT that corresponds to a delay:

from a rising/falling of the (further) first control signal described above provided by the first (or second) dead time conditioning block $352_P$ (or $352_M$) to a subsequent falling/rising of the (further) second control signal described above provided by such first (or second) dead time conditioning block $352_P$ (or $352_M$).

It is noted that such dead time delay DT is considered in order to avoid that a high-side switch, that is, HP or HM, and the low-side switch comprised in the same branch of the full-bridge, that is, LP or LM respectively, are set to a conductive state simultaneously.

It is noted that for values of the output current $I_{out}$ close to zero, that is, for low output current $I_{out}$ values, the values of the previously described time delays $T_{d\_r\_M}$, $T_{d\_f\_P}$, $T_{d\_r\_P}$, and $T_{d\_f\_M}$ are close to each other, for instance, close to a value DTZ that depends on the dead time delay DT and on a value of a ripple current (for instance, when the current flowing in the load LD is zero).

It is also noted that with the increasing of the absolute value of the output current $I_{out}$, the values of the previously described time delays $T_{d\_r\_M}$, $T_{d\_f\_P}$, $T_{d\_r\_P}$, and $T_{d\_f\_M}$ diverge from the value DTZ obtained at zero output load current.

In this regard, the third time delay $T_{d\_r\_M}$ and the second time delay $T_{d\_f\_P}$ show a similar behavior, with values that:

decrease with respect to the value of the time delay DTZ for negative values of the output current $I_{out}$, that is, when the output current $I_{out}$ flows from the first output node $Out_P$ to the second output node $Out_M$, and increase with respect to the value of the time delay DTZ for positive values of the output current $I_{out}$, that is, when the output current $I_{out}$ flows from the second output node $Out_M$ to the first output node $Out_P$.

Similarly, the first time delay $T_{d\_r\_P}$ and the fourth time delay $T_{d\_f\_M}$ show a similar behavior, with values that:

decrease with respect to the value of the time delay DTZ for positive values of the output current $I_{out}$, and increase with respect to the value of the time delay DTZ for negative values of the output current $I_{out}$.

Therefore, in normal driving conditions, that is, in absence of short circuits, the behavior (and the value) of the third time delay $T_{d\_r\_M}$ is almost equal to the behavior (and the value) of the second time delay $T_{d\_f\_P}$ and the behavior (and the value) of the first time delay $T_{d\_r\_P}$ is almost equal to the behavior (and the value) of the fourth time delay $T_{d\_f\_M}$.

It is noted that behaviors of time delays measured on a same branch of the full-bridge, that is, the first time delay $T_{d\_r\_P}$ and the second time delay $T_{d\_f\_P}$ or the third time delay $T_{d\_r\_M}$ and the fourth time delay $T_{d\_f\_M}$, are almost symmetrical, with the output current $I_{out}$ changed in sign.

It is noted that the behaviors illustrated in Figure 9 are present both in BD, that is, when the fronts of the first input signal $D_{INP}$ and those of the second input signal $D_{INM}$ are not synchronous, and AD modulation, that is, when the fronts of the first input signal $D_{INP}$ and those of the second input signal $D_{INM}$ are synchronous, for instance, in response to the first input signal $D_{INP}$ being equal to the inversion (for instance, obtained by logic negation) of the second input signal $D_{INM}$.

In addition, the behaviors illustrated in Figure 9 may also be present in ZSL ("Zero Switching Loss") class-D amplifiers, therefore, solutions as described herein may also be applied to such amplifiers, by treating them as amplifiers having AD modulation since the time delays are the same in case of exiting and entering currents and decrease or increase in response to the decreasing or the increasing of the output current, in particular in case of low positive output currents and negative currents.

A short circuit condition to the supply voltage VCC or to ground GND is detected when an unbalance is present between:

the third time delay $T_{d\_r\_M}$ and the second time delay $T_{d\_f\_P}$, which in normal driving conditions (that is, in absence of short circuits) have an almost equal behavior; or the first time delay $T_{d\_r\_P}$ and the fourth time delay $T_{d\_f\_M}$, which in normal driving conditions have an almost equal behavior.

The unbalance between such third time delay

$T_{d\_r\_M}$ and such second time delay $T_{d\_f\_P}$ or between such first time delay $T_{d\_r\_P}$ and such fourth time delay $T_{d\_f\_M}$ can be detected when an absolute value of a difference between the value of such two considered time delays (which are supposed to be almost equal since their behavior is almost equal) is above a time threshold.

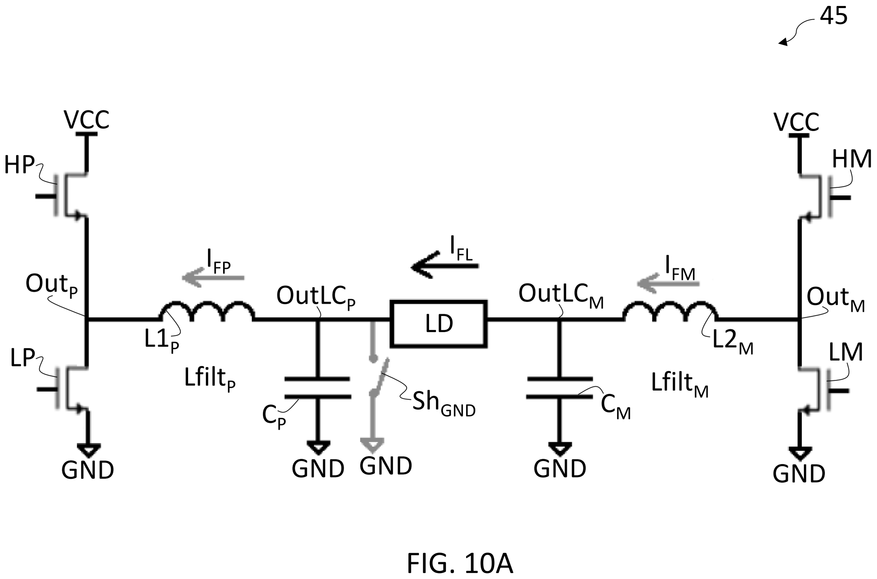

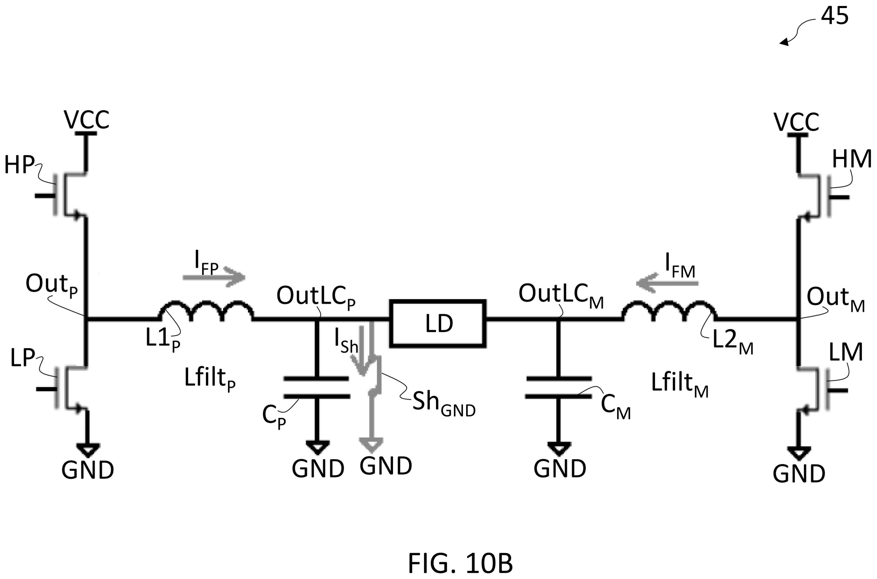

Figures 10A and 10B illustrate a full-bridge class-D amplifier 45 having an exemplary short circuit $Sh_{GND}$ to ground GND applied when the outputs $Out_P$ and $Out_M$ of the amplifier 45 are not saturated (that is, when the first input signal $D_{INP}$ and the second input signal $D_{INM}$ are switching), in embodiments that considers the further approach described above.

The presence of the short circuit $Sh_{GND}$ to ground GND breaks the symmetry on the currents flowing out $I_{FM}$ of the second output node $Out_M$ and into $I_{FP}$ the first output node $Out_P$, passing $I_{FL}$ through the load LD, therefore, such currents have different values in response to the presence of such short circuit $Sh_{GND}$.

For instance, in the exemplary scenario of Figures 10A and 10B, the short circuit $Sh_{GND}$ to ground GND is considered on one of the output nodes of the full-bridge, for example, on the first output node $Out_P$ where the current $I_{FP}$ is entering, after the LC filtering stage, for example, after the first LC filter $Lfilt_P$ and in correspondence of the first output node of the LC filtering stage $OutLC_P$.

In addition, in the exemplary scenario of Figures 10A and 10B, it is supposed that:

the load LD remains coupled between the first output node of the LC filtering stage $OutLC_P$ and the second output node of the LC filtering stage $OutLC_M$ after the short circuit $Sh_{GND}$ event, and
the current $I_{FL}$ flowing through the load LD was positive before the short circuit $Sh_{GND}$ event, that is, was flowing from the second output node $Out_M$ to the first output node $Out_P$.

It is noted that in Figure 10A, before the short circuit $Sh_{GND}$ event to ground GND, the current $I_{FP}$ flowing into the first output node $Out_P$ has a positive value since the output current $I_{out}$ (composed of the current $I_{FM}$ provided by the second output node $Out_M$ and the current $I_{FP}$ absorbed by the first output node $Out_P$) is flowing from the second output node $Out_M$ to the first output node $Out_P$.

Therefore, supposing that:

the first input signal $D_{INP}$ is in correspondence of a falling edge, switching from a high logic level to a low logic level, and
the second input signal $D_{INM}$ is in correspondence of a rising edge, switching from a low logic level to a high logic level,
a measured second time delay $T_{d\_f\_P}$ and a measured third time delay $T_{d\_r\_M}$ are (almost) equal and, according to the behaviors illustrated in Figure 9, have a value above the previously described time delay value DTZ.

In response to the short circuit $Sh_{GND}$ event to ground GND, the current $I_{FP}$ flowing into the first output node $Out_P$ starts to decrease and, after a given time, changes its sign (polarity), that is, changes its flow direction (referring to Figure 10B), by flowing out from the first output node $Out_P$ to ground $I_{sh}$.

In response to the changing of the flow direction of the current $I_{FP}$ flowing out from the first output node Outp, the measured second time delay $T_{d\_f\_P}$ reduces its value from a value higher than the value of the time delay DTZ to a value lower than such time delay value DTZ.

In fact, in response to the short circuit $Sh_{GND}$ event to ground GND, the current $I_{FP}$ is provided as output (and not absorbed) by the first output node $Out_P$ (referring to Figure 10B), therefore, such current $I_{FP}$ has a negative value since the output current $I_{out}$ flows out of the first output node $Out_P$ to ground $IS_h$.

Differently, the current $I_{FM}$ is still provided as output by the second output node $Out_M$ and (slowly) increases due to the load LD presence between such second output node $Out_M$ and the short circuit $Sh_{GND}$ to ground GND.

Therefore, while the value of the measured second time delay $T_{d\_f\_P}$ is reduced, the measured third time delay $T_{d\_r\_M}$:

maintains its value above the value of the time delay DTZ as the current $I_{FM}$ is still provided as output by the second output node $Out_M$, and
(slowly) increases in response to the (slow) increase of such current $I_{FM}$ due to the load LD presence between the second output node $Out_M$ and the short circuit $Sh_{GND}$ to ground GND.

Therefore, an unbalance between the measured second time delay $T_{d\_f\_P}$ and the measured third time delay $T_{d\_r\_M}$ is present.

A similar conclusion may be drawn also by supposing that:

the first input signal $D_{INP}$ is in correspondence of a rising edge, switching from a low logic level to a high logic level, and
the second input signal $D_{INM}$ is in correspondence of a falling edge, switching from a high logic level to a low logic level.

In such a case, a measured first time delay $T_{d\_r\_P}$ and a measured fourth time delay $T_{d\_f\_M}$ are (almost) equal and, according to the behaviors illustrated in Figure 9, have a value below the value of the time delay DTZ.

In response to the short circuit $Sh_{GND}$ event to ground GND, the current $I_{FP}$ flowing into the first output node Out$_P$ starts to decrease and, after a given time, changes its sign (polarity), that is, changes its flow direction (referring to Figure 10B), by flowing out from the first output node Out$_P$ to ground I$_{sh}$.

In response to the changing of the flow direction of the current I$_{FP}$ flowing out from the first output node Outp, the measured first time delay T$_{d\_r\_P}$ increases its value from a value lower than the value of the time delay DTZ to a value higher than such time delay value DTZ.

In fact, in response to the short circuit Sh$_{GND}$ event to ground GND, the current I$_{FP}$ is provided as output (and not absorbed) by the first output node Out$_P$ (referring to Figure 10B), therefore, such current I$_{FP}$ has a negative value since the output current I$_{out}$ flows out of the first output node Out$_P$ to ground IS$_h$.

Differently, the current I$_{FM}$ is still provided as output by the second output node Out$_M$ and (slowly) increases due to the load LD presence between such second output node Out$_M$ and the short circuit Sh$_{GND}$ to ground GND.

Therefore, while the value of the measured first time delay T$_{d\_r\_P}$ is increased, the measured fourth time delay T$_{d\_f\_M}$:

  maintains its value below the value of the time delay DTZ as the current I$_{FM}$ is still provided as output by the second output node Out$_M$, and
  (slowly) decreases in response to the (slow) increase of such current I$_{FM}$ due to the load LD presence between the second output node Out$_M$ and the short circuit Sh$_{GND}$ to ground GND.

Therefore, also in such case, an unbalance between the measured first time delay T$_{d\_r\_P}$ and the measured fourth time delay T$_{d\_f\_M}$ is present.

In both the described cases, such unbalance may be obtained by performing a subtraction operation between:

  the measured second time delay T$_{d\_f\_P}$ and the measured third time delay T$_{d\_r\_M}$, or
  the measured first time delay T$_{d\_r\_P}$ and the measured fourth time delay T$_{d\_f\_M}$,
  obtaining a time delay difference as the absolute value of the result of the subtraction operation.

Hence, by comparing the obtained time delay difference with a threshold, it is possible to:

  detect a short circuit presence in response to such time delay difference being higher than (or eventually equal to) the threshold; and
  detect a short circuit absence in response to such time delay difference being lower than the threshold.

For instance, in solutions using the further approach described herein, a threshold value may be in the order of a quarter of the dead time delay DT (for instance, in the exemplary scenario of Figure 9, the threshold may assume a value equal to 5 ns - "nanoseconds").

It is noted that same conclusions are considered if the short circuit Sh$_{GND}$ to ground GND is present on the second output node Out$_M$ where the current I$_{FM}$ is exiting, for example, after the second LC filter Lfilt$_M$ and in correspondence of the second output node of the LC filtering stage OutLC$_M$.

In fact, also in such a case an unbalance is present between the measured second time delay T$_{d\_f\_P}$ and the measured third time delay T$_{d\_r\_M}$ or the measured first time delay T$_{d\_r\_P}$ and the measured fourth time delay T$_{d\_f\_M}$.

In response to the short circuit Sh$_{GND}$ event to ground GND on the second output node Out$_M$, the current I$_{FP}$ flowing into the first output node Out$_P$ starts to (slowly) decrease due to the load LD presence between such first output node Out$_P$ and the short circuit Sh$_{GND}$ to ground GND, therefore, (slowly) reducing the measured second time delay T$_{d\_f\_P}$ and (slowly) increasing the measured first time delay T$_{d\_r\_P}$.

In addition, the current I$_{FM}$ provided as output by the second output node Out$_M$ increases, therefore, increasing the measured third time delay T$_{d\_r\_M}$ and decreasing the measured fourth time delay T$_{d\_f\_M}$.

It is also noted that the exemplary scenario of Figures 10A and 10B considers an AD modulation, however, the conclusions described above may be considered valid also in solutions using BD modulation, provided that measured time delays T$_{d\_f\_P}$, T$_{d\_r\_M}$, T$_{d\_r\_P}$, and T$_{d\_f\_M}$ are stored, for instance, in respective capacitors by voltage conversion, and then elaborated via the previously described subtraction operation and comparing operation. In fact, by storing the measured time delays T$_{d\_f\_P}$, T$_{d\_r\_M}$, T$_{d\_r\_P}$, and T$_{d\_f\_M}$ it is possible to overcome the fact that pulses in BD modulation are not synchronous and not overlapping.

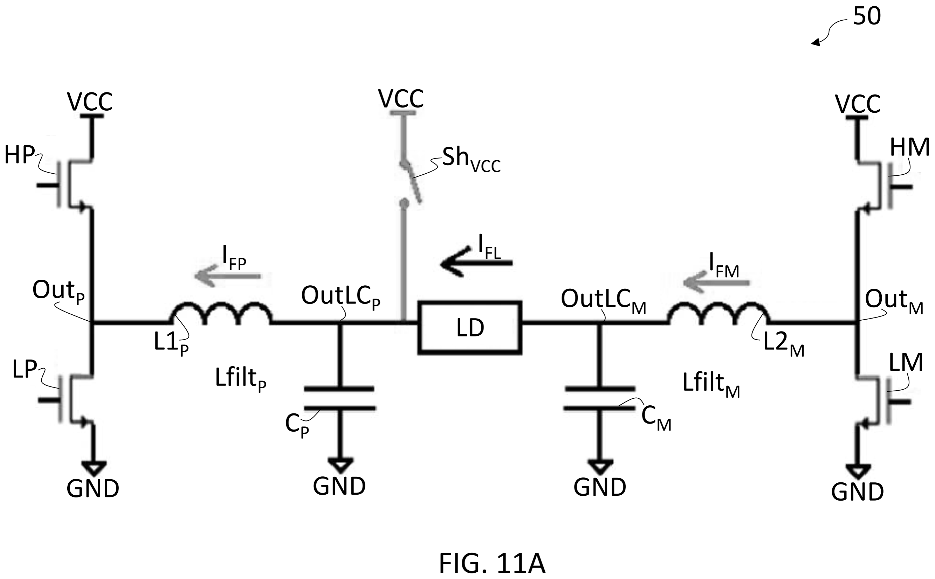

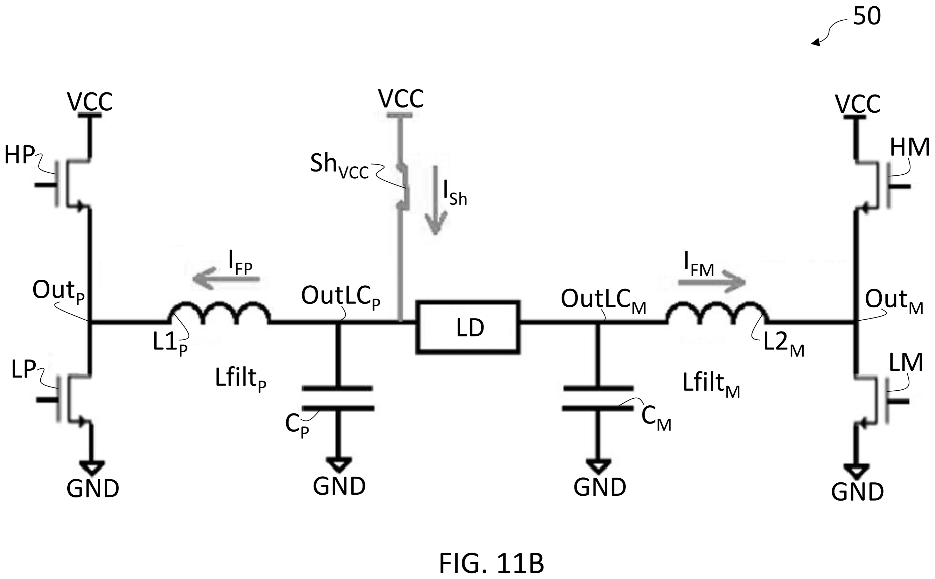

Figures 11A and 11B illustrate a full-bridge class-D amplifier 50 having an exemplary short circuit Sh$_{VCC}$ to the supply voltage VCC applied when the outputs Out$_P$ and Out$_M$ of the amplifier 50 are not saturated (that is, when the first input signal D$_{INP}$ and the second input signal D$_{INM}$ are switching) in embodiments that considers the further approach described above.

The presence of the short circuit Sh$_{VCC}$ to the supply voltage VCC breaks the symmetry on the currents flowing out I$_{FM}$ of the second output node Out$_M$ and into I$_{FP}$ the first output node Out$_P$, passing I$_{FL}$ through the load LD, therefore, leading to different values of such currents.

In fact, such presence of the short circuit Sh$_{VCC}$ to the supply voltage VCC leads to:

  a current injection into one of the two outputs Out$_P$ or Out$_M$ of the full-bridge, that is, into the output node of the full-bridge currently coupled to ground GND and that receives an entering current, thus, increasing the current flowing in such output node of an amount equal to the injected current I$_{Sh}$; and

a reduction of a current flowing in the other output of the full-bridge, that is, in the output node of the full-bridge currently coupled to the supply voltage VCC and that provides the output current $I_{out}$, thus, reducing and, after a given time, changing the polarity (sign) of the current exiting from such other output node.

For instance, in the exemplary scenario of Figures 11A and 11B, the short circuit $Sh_{VCC}$ to the supply voltage VCC is considered on one of the output nodes of the full-bridge, for example, on the first output node $Out_P$ where the current $I_{FP}$ is entering, after the LC filtering stage, for example, after the first LC filter $Lfilt_P$ and in correspondence of the first output node of the LC filtering stage $OutLC_P$.

In addition, in the exemplary scenario of Figures 11A and 11B, it is supposed that:

the load LD remains coupled between the first output node of the LC filtering stage $OutLC_P$ and the second output node of the LC filtering stage $OutLC_M$ after the short circuit $Sh_{VCC}$ event, and
the current $I_{FL}$ flowing through the load LD was positive before the short circuit $Sh_{VCC}$ event, that is, was flowing from the second output node $Out_M$ to the first output node $Out_P$.

Therefore, it is noted that, in the exemplary scenario illustrated in such Figures 11A and 11B:

the first output node $Out_P$ is the output node currently coupled to ground GND having an entering current, thus, is the output node where the (positive) current $I_{Sh}$ generated by the short circuit $Sh_{VCC}$ event is injected, increasing the current $I_{FP}$ flowing therein; and
the second output node $Out_M$ is the output node currently coupled to the supply voltage VCC and that provides the output current $I_{out}$, thus, is the output node where the current $I_{FM}$ that flows therein is reduced and, after a given time, changes polarity (referring to Figure 11B).

Therefore, in response to the short circuit $Sh_{VCC}$ event to the supply voltage VCC, the current $I_{FP}$ flowing into the first output node $Out_P$ increases, thus, a measured second time delay $T_{d\_f\_P}$ increases and a measured first time delay $T_{d\_r\_P}$ decreases.

In response to the short circuit $Sh_{VCC}$ event to the supply voltage VCC, the current $I_{FM}$ provided by the second output node $Out_M$ decreases and, after a given time, changes polarity, starting to enter into the second output node $Out_M$.

Therefore, a measured third time delay $T_{d\_r\_M}$ decreases from a value higher than the value of the time delay DTZ to a value lower than such time delay value DTZ and a measured fourth time delay $T_{d\_f\_M}$ increases from a value lower than the value of the time delay DTZ to a value higher than such time delay value DTZ.

Therefore, an unbalance between the measured second time delay $T_{d\_f\_P}$ and the measured third time delay $T_{d\_r\_M}$ or the measured first time delay $T_{d\_r\_P}$ and the measured fourth time delay $T_{d\_f\_M}$ is present.

Such unbalance may be obtained by performing a subtraction operation between:

the measured second time delay $T_{d\_f\_P}$ and the measured third time delay $T_{d\_r\_M}$, or
the measured first time delay $T_{d\_r\_P}$ and the measured fourth time delay $T_{d\_f\_M}$,
obtaining a time delay difference as the absolute value of the result of the subtraction operation.

Hence, by comparing the obtained time delay difference with a threshold, it is possible to:

detect a short circuit presence in response to such time delay difference being higher than (or eventually equal to) the threshold; and
detect a short circuit absence in response to such time delay difference being lower than the threshold.

For instance, also in case of short circuits to the supply voltage VCC and in solutions using the further approach described herein, a threshold value may be in the order of a quarter of the dead time delay DT (for instance, in the exemplary scenario of Figure 9, the threshold may assume a value equal to 5 ns - "nanoseconds").

It is noted that same conclusions are considered if the short circuit $Sh_{VCC}$ to the supply voltage VCC is present on the second output node $Out_M$ where the current $I_{FM}$ is exiting, for example, after the second LC filter $Lfilt_M$ and in correspondence of the second output node of the LC filtering stage $OutLC_M$.

In general, in solutions using both AD modulation and the further time-based approach described above, it is not requested to measure separately and then compare, for instance, via the described subtraction operation and comparing with the threshold operation, the time delays $T_{d\_f\_P}$ and $T_{d\_r\_M}$ or $T_{d\_r\_P}$ and $T_{d\_f\_M}$.

In such a case, it may be sufficient to measure a PWM delay between the switching of the PWM signal provided as output by the first high-side switch HP or the first low-side switch LP via the first output node $Out_P$ and the switching of the PWM signal provided as output by the second high-side switch HM or the second low-side switch LM via the second output node $Out_M$, or viceversa.

It is noted that temperature mismatches of the switches comprised in the full-bridge or the presence of non-negligible substrate injection may result in systematic current dependent delays of the fronts of the PWM signals, which can be compensated during the measurement of the PWM delay.

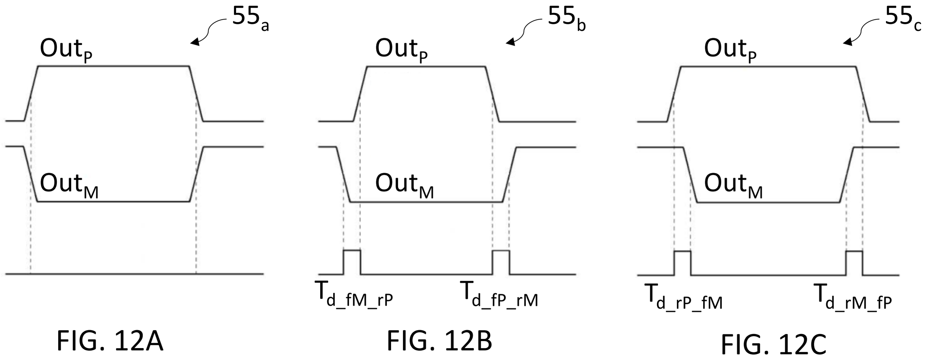

Figures 12A, 12B, and 12C illustrate behaviors

$55_a$, $55_b$, and $55_c$ respectively of fronts of PWM signals provided as output by the full-bridge class-D amplifier according to embodiments of the present description related to the AD modulation case.

Figure 12A illustrates the switching (rising and falling) of the PWM signal provided as output by the first high-side switch HP or the first low-side switch LP via the first output node $Out_P$ and the corresponding switching (falling and rising) of the PWM signal provided as output by the second high-side switch HM or the second low-side switch LM via the second output node $Out_M$ during normal driving conditions, that is, in absence of short circuits.

It is noted that in such normal driving conditions, that is, in absence of short circuits and if the full-bridge class-D amplifier is operated via the AD modulation, the rising (or falling) of the PWM signal provided by the first output node $Out_P$ and the corresponding falling (or rising) of the PWM signal provided by the second output node $Out_M$ are synchronous.

Figure 12B illustrates the switching (rising and falling) of the PWM signal provided as output by the first high-side switch HP or the first low-side switch LP via the first output node $Out_P$ and the corresponding switching (falling and rising) of the PWM signal provided as output by the second high-side switch HM or the second low-side switch LM via the second output node $Out_M$ during a short circuit $Sh_{GND}$ event to ground GND.

It is noted that in conditions where a short circuit $Sh_{GND}$ event to ground GND is present, the rising fronts of the PWM signal provided by the first output node $Out_P$ are delayed with respect to the falling fronts of the PWM signal provided by the second output node $Out_M$, and the rising fronts of the PWM signal provided by the second output node $Out_M$ are delayed with respect to the falling fronts of the PWM signal provided by the first output node $Out_P$.

In such a case, the absolute value of the difference between the first time delay $T_{d\_r\_P}$ and the fourth time delay $T_{d\_f\_M}$ is equal to a first PWM delay $T_{d\_fM\_rP}$ measured between the falling edge of the PWM signal provided by the second output node $Out_M$ and the rising edge of the PWM signal provided by the first output node $Out_P$.

If such first PWM delay $T_{d\_fM\_rP}$ is above a threshold, for instance, a threshold in the order of a quarter of the dead time delay DT (for instance, 5 ns - "nanoseconds"), the presence of a short circuit $Sh_{GND}$ event to ground GND is determined.

Similarly, the absolute value of the difference between the third time delay $T_{d\_r\_M}$ and the second time delay $T_{d\_f\_P}$ is equal to a second PWM delay $T_{d\_fP\_rM}$ measured between the falling edge of the PWM signal provided by the first output node $Out_P$ and the rising edge of the PWM signal provided by the second output node $Out_M$.

Therefore, if such second PWM delay $T_{d\_fP\_rM}$ is above such threshold, for instance, in the order of a quarter of the dead time delay DT, the presence of a short circuit $Sh_{GND}$ event to ground GND is determined.

Figure 12C illustrates the switching (rising and falling) of the PWM signal provided as output by the first high-side switch HP or the first low-side switch LP via the first output node $Out_P$ and the corresponding switching (falling and rising) of the PWM signal provided as output by the second high-side switch HM or the second low-side switch LM via the second output node $Out_M$ during a short circuit $Sh_{VCC}$ event to the supply voltage VCC.

It is noted that in conditions where a short circuit $Sh_{VCC}$ event to the supply voltage VCC is present, the falling fronts of the PWM signal provided by the first output node $Out_P$ are delayed with respect to the rising fronts of the PWM signal provided by the second output node $Out_M$, and the falling fronts of the PWM signal provided by the second output node $Out_M$ are delayed with respect to the rising fronts of the PWM signal provided by the first output node Outp.

In such a case, the absolute value of the difference between the first time delay $T_{d\_r\_P}$ and the fourth time delay $T_{d\_f\_M}$ is equal to a third PWM delay $T_{d\_rP\_fM}$ measured between the rising edge of the PWM signal provided by the first output node $Out_P$ and the falling edge of the PWM signal provided by the second output node $Out_M$.

If such third PWM delay $T_{d\_rP\_fM}$ is above such threshold, for instance, a threshold in the order of a quarter of the dead time delay DT, the presence of a short circuit $Sh_{VCC}$ event to the supply voltage VCC is determined.

Similarly, the absolute value of the difference between the third time delay $T_{d\_r\_M}$ and the second time delay $T_{d\_f\_P}$ is equal to a fourth PWM delay $T_{d\_rM\_fP}$ measured between the rising edge of the PWM signal provided by the second output node $Out_M$ and the falling edge of the PWM signal provided by the first output node $Out_P$.

Therefore, if such fourth PWM delay $T_{d\_rM\_fP}$ is above such threshold, for instance, in the order of a quarter of the dead time delay DT, the presence of a short circuit $Sh_{VCC}$ event to the supply voltage VCC is determined.

In general, in solutions using both BD modulation and the further time-based approach described above, different implementations can be used, provided that the values of the time delays $T_{d\_f\_P}$ and $T_{d\_r\_M}$ or $T_{d\_r\_P}$ and $T_{d\_f\_M}$ are stored before the comparison operation, for instance, performed via the described subtraction operation and comparing with the threshold operation.

Therefore, the measuring unit comprised in circuits according to solutions as described herein may comprise:

a first storing unit, for instance, a storing unit having a structure of a storing unit 604 described in the following, configured to store the first measure described above, and

a second storing unit, for instance, again a storing unit having a structure of the storing unit 604 described in the following, configured to store the second measure described above.

In such a case, the checking unit described above may be configured to receive the first measure and the second measure from such first storing unit and such second storing unit, respectively, comprised in the measuring unit.

In addition, the first storing unit may be a first capacitor configured to store a voltage indicative of the first measure, and the second storing unit may be a second capacitor configured to store a voltage indicative of the second measure.

It is noted that, in such a case, such checking unit may be configured to receive the voltage indicative of the first measure and the voltage indicative of the second measure from such first storing unit and such second storing unit, respectively, comprised in the measuring unit.

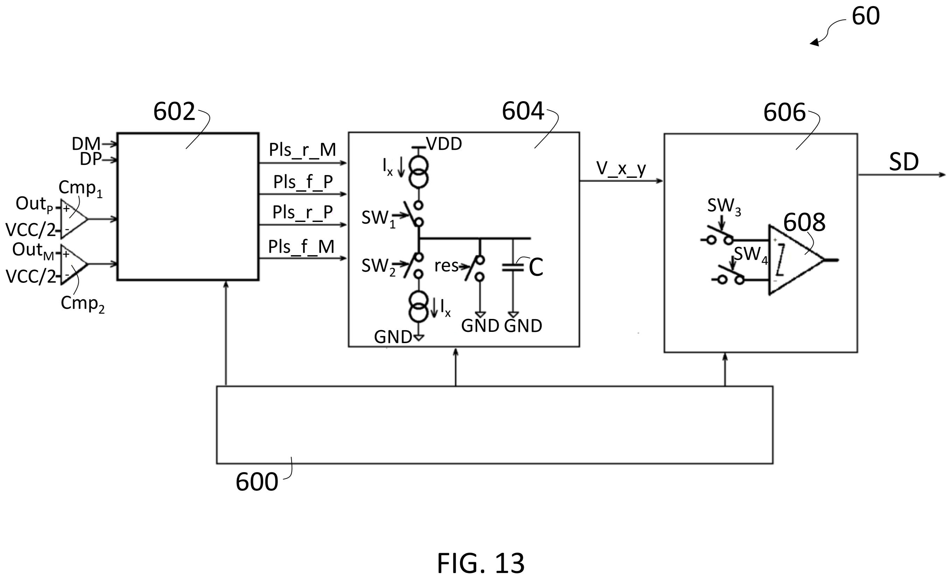

Figure 13 illustrates a third exemplary circuit 60 for detecting short circuits based on time measurements according to embodiments of solutions using BD modulation. It is noted that, as described above, the implementation illustrated in Figure 13 is only one of the possible implementations of solutions using both BD modulation and the further time-based approach described above.

In solutions according to Figure 13, the PWM signal provided by the first output node $Out_P$ is converted into a first logic signal via a first comparator $Cmp_1$.

Such first comparator $Cmp_1$ may be configured:

to receive such PWM signal provided by the first output node $Out_P$ and a voltage reference threshold, for instance, having a value equal to VCC/2, and to provide as output such first logic signal based on a comparison between the received PWM signal provided by the first output node $Out_P$ and the voltage reference threshold.

For instance, the first logic signal may have:

a high logic level in response to the PWM signal provided by the first output node $Out_P$ being higher than the voltage reference threshold; and a low logic level in response to the PWM signal provided by the first output node $Out_P$ being lower than the voltage reference threshold.

Similarly, the PWM signal provided by the second output node $Out_M$ is converted into a second logic signal via a second comparator $Cmp_2$.

Such second comparator $Cmp_2$ may be configured:

to receive such PWM signal provided by the second output node $Out_M$ and such voltage reference threshold, and to provide as output such second logic signal based on a comparison between the received PWM signal provided by the second output node $Out_M$ and the voltage reference threshold.

For instance, the second logic signal may have:

a high logic level in response to the PWM signal provided by the second output node $Out_M$ being higher than the voltage reference threshold; and a low logic level in response to the PWM signal provided by the second output node $Out_M$ being lower than the voltage reference threshold.

The first logic signal, the second logic signal, and further driver control signals (for instance, a driver minimum signal DM and a driver pin signal DP) are provided to a logic unit 602.

The logic unit 602 may be configured to generate, based on the received signals, logic pulse signals Pls_r_M, Pls_f_P, Pls_r_P, and Pls_f_M indicative of respective time delays $T_{d\_r\_m}$, $T_{d\_f\_P}$, $T_{d\_r\_P}$, and $T_{d\_f\_M}$, for instance, having a width equal to such respective time delays.

The logic pulse signals Pls_r_M, Pls_f_P, Pls_r_P, and Pls_f_M may be provided to a storing unit 604 that may be configured according to two possible implementations.

In a first implementation, such storing unit 604 can be configured to convert such logic pulse signals into delay-related voltages V_r_M, V_f_P, V_r_P, and V_f_M by charging respective capacitors C (previously discharged) with a reference current $I_x$ for the duration of the respective width of the considered logic pulse signal, and to store such delay-related voltages.

It is noted that such reference current $I_x$ is a current having a constant value that may be obtained with any type of known constant current source, for instance, by using a constant current generator as illustrated in the storing unit 604 in Figure 13.

For example, an exemplary circuit that can be used for charging and/or discharging the respective capacitors C may comprise:

a first switch $SW_1$ coupled between a certain supply voltage of the capacitor VDD and a node, and configured to close in order to let the reference current $I_x$ flow between such supply voltage VDD and the node; a second switch $SW_2$ coupled between such node and ground GND, and configured to close in order to let the reference current $I_x$ flow between such node and ground GND; the respective capacitor C coupled between such node and ground GND, and configured to be charged or discharged with such reference current $I_x$; and

a third switch res coupled between such node and ground GND, and configured to close in order to discharge such capacitor C.

It is noted that a respective capacitor C and a corresponding circuit as the one described above may be present for each one of the time delays $T_{d\_r\_M}$, $T_{d\_f\_P}$, $T_{d\_r\_P}$, and $T_{d\_f\_M}$ that is to be stored.

Alternatively, a first capacitor C and a first exemplary circuit may be present for the high-side switch of a branch of the full-bridge and a second capacitor C and a second exemplary circuit may be present for the low-side switch of the other branch of such full-bridge, such first and second exemplary circuits being coupled, for example, to respective multiplexing units in order to receive the logic pulse signals Pls_r_M or Pls_f_P and Pls_r_P or Pls_f_M respectively.

Once such respective capacitors C (for instance, considering a capacitor C for each time delay) store the delay-related voltages V_r_M, V_f_P, V_r_P, and V_f_M, voltage differences between V_r_M and V_f_P or V_r_P and V_f_M may be computed by any known circuit configured to perform voltage comparison operations via voltage comparators, switch-cap, current mirror (after a voltage to current conversion), or the like, for instance, the comparison unit 606 of Figure 13.

Such voltage differences between V_r_M and V_f_P or V_r_P and V_f_M are used to detect unbalances and, as a consequence, the presence of a short circuit, for instance, by checking if an absolute value of any one of such voltage differences is above a voltage threshold.

For instance, an operation of detecting unbalances may comprise comparing an absolute value of one of such voltage differences between V_r_M and V_f_P or V_r_P and V_f_M with a voltage threshold, and indicating the presence of a short circuit if the absolute value of the considered voltage difference V_r_M-V_f_P or V_r_P-V_f_M is above the voltage threshold or the absence of a short circuit if such absolute value of the considered voltage difference is below the voltage threshold.

It is noted that such second delay-related voltage V_f_P is equal to the third delay-related voltage V_r_M in normal driving conditions, that is, in absence of short circuits.

It is also noted that such fourth delay-related voltage V_f_M is equal to the first delay-related voltage V_r_P in normal driving conditions.

In a second implementation, a capacitor C is pre-charged at a given voltage, for instance, equal to half the supply voltage of the capacitor VDD/2. The reference current $I_x$ can be used to charge such capacitor C by considering the logic pulse Pls_r_M, and then to discharge such capacitor C with such reference current $I_x$ by considering the logic pulse Pls_f_P, obtaining a first capacitor voltage equal to VDD/2+V_r_M-V_f_P.

The same can be done with a second capacitor, charged by considering the logic pulse Pls_f_M, and then discharged by considering the logic pulse Pls_r_P, obtaining a second capacitor voltage equal to VDD/2+V_f_M-V_r_P.

The first capacitor voltage and the second capacitor voltage may be compared with at least one voltage threshold, for instance:

with a high voltage threshold VTP equal to half the supply voltage VCC plus a given margin VX, that is,

$$\overline{VTP} = \frac{VCC}{2} + VX \text{, and}$$

with a low voltage threshold VTN equal to half the voltage supply VCC minus the given margin VX, that is, $VTN = \frac{VCC}{2} - VX$ .

For instance, such comparison operation may be performed via a comparator 608 configured to receive:

at a first input terminal, via a fourth switch $SW_3$, the first capacitor voltage or the second capacitor voltage; and

at a second input terminal, via a fifth switch $SW_4$, the voltage threshold, for instance, either the voltage threshold plus the given margin or the voltage threshold minus the given margin;

and to compare the received inputs, providing as output a short circuit detection signal SD.

The short circuit detection signal SD indicates the presence of a short circuit if:

the received first capacitor voltage or second capacitor voltage is above the high voltage threshold VTP, that is, is above the voltage threshold plus the given margin, or

the received first capacitor voltage or second capacitor voltage is below the low voltage threshold VTN, that is, is below the voltage threshold minus the given margin.

Otherwise, the short circuit detection signal SD indicates the absence of a short circuit.

It is noted that the logic unit 602, the storing unit 604, and the comparison unit 606 may be controlled via a state machine logic 600.

Hence, for instance, the operation of determining the absolute value of the difference between the first measure and the second measure described above may comprise:

pre-charging a capacitor C to a reference voltage, preferably having a value equal to half the supply voltage VCC;

charging such capacitor C with a first voltage, such first voltage being indicative of the first measure; discharging such capacitor C with a second voltage, such second voltage being indicative of the second measure, obtaining a capacitor voltage; and providing a first capacitor voltage equal to such capacitor voltage plus a margin and a second capacitor voltage equal to such capacitor voltage minus the margin as the absolute value of the difference between such first measure and such second measure.

In such a case, the operation of checking whether such absolute value of the difference is higher than a threshold described above may comprise checking, for instance, via respective comparators 608, whether:

such first capacitor voltage is lower than such voltage reference, that is, whether such capacitor voltage is lower than the voltage reference minus the margin, or
such second capacitor voltage is higher than such voltage reference, that is, whether such capacitor voltage is higher than the voltage reference plus the margin.

In general, also solutions using both AD modulation and the further time-based approach described above may be implemented via different circuits.

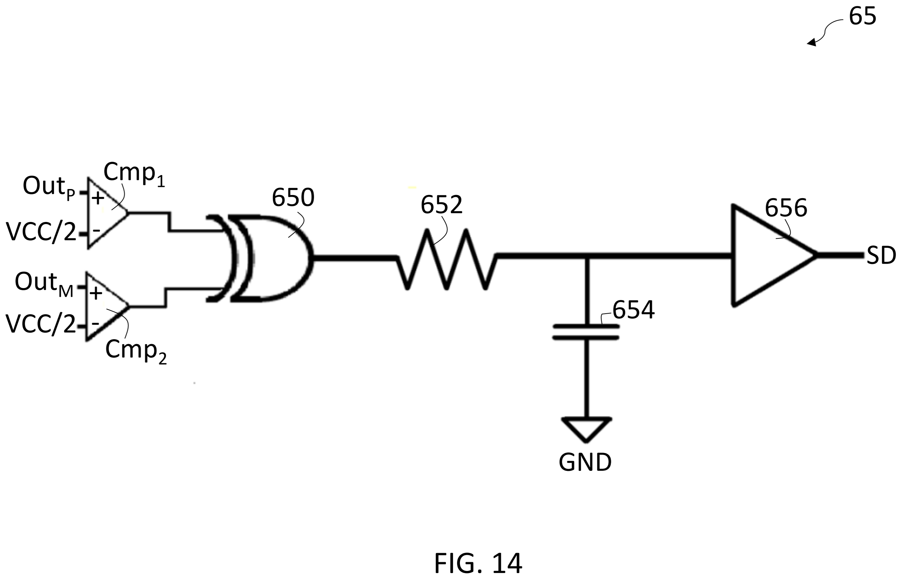

Figure 14 illustrates a further exemplary circuit 60 for detecting short circuits based on time measurements in AD modulation conditions according to embodiments of the present description. It is noted that, as described above, the implementation illustrated in Figure 14 is only one of the possible implementations of solutions using both AD modulation and the further time-based approach described above.

In fact, as previously described for AD modulation in case of a short circuit to ground GND, the first PWM delay $T_{d\_fM\_rP}$, the second PWM delay $T_{d\_fP\_rM}$, the third PWM delay $T_{d\_rP\_fM}$, and the fourth PWM delay $T_{d\_rM\_fP}$ may be measured via direct logic elaboration of the PWM signal provided by the first output node $Out_P$ and the PWM signal provided by the second output node $Out_M$. A same conclusion is also valid in case of short circuits to the supply voltage VCC.

A first implementation (not illustrated in Figure 14) may be obtained by a circuit configured to evaluate the width of such PWM delays, by converting them into voltages and by comparing the obtained voltages with a reference voltage generated by a known time pulse.

Figure 14 illustrates a simpler implementation that can be used if a high accuracy is not required.

In solutions according to Figure 14, the PWM signal provided by the first output node $Out_P$ is converted into a first logic signal via a first comparator $Cmp_1$.

Such first comparator $Cmp_1$ may be configured:

to receive such PWM signal provided by the first output node $Out_P$ and a voltage reference threshold, for instance, having a value equal to VCC/2, and
to provide as output such first logic signal based on a comparison between the received PWM signal provided by the first output node $Out_P$ and the voltage reference threshold, for instance, by providing as output a high logic level when such PWM signal provided by the first output node $Out_P$ is higher than the voltage reference threshold and a low logic level otherwise.

Similarly, the PWM signal provided by the second output node $Out_M$ is converted into a second logic signal via a second comparator $Cmp_2$.

Such second comparator $Cmp_2$ may be configured:

to receive such PWM signal provided by the second output node $Out_M$ and such voltage reference threshold, and
to provide as output such second logic signal based on a comparison between the received PWM signal provided by the second output node $Out_M$ and the voltage reference threshold, for instance, by providing as output a high logic level when such PWM signal provided by the second output node $Out_M$ is higher than such voltage reference threshold and a low logic level otherwise.

The first logic signal and the second logic signal are provided to a logic XOR block 650 configured to perform a logic XOR operation on such first logic signal and such second logic signal.

It is noted that, during the first PWM delay $T_{d\_fM\_rP}$, the second PWM delay $T_{d\_fP\_rM}$, the third PWM delay $T_{d\_rP\_fM}$, and the fourth PWM delay $T_{d\_rM\_fP}$, the XOR of the first logic signal and the second logic signal provided as output by the logic XOR block 650 may assume a low logic level (thus, indicating the absence of a short circuit to the supply voltage VCC or to ground), otherwise, such result of the XOR operation may assume a high logic level (thus, indicating the presence of a short circuit).

The XOR of the first logic signal and the second logic signal provided as output by the logic XOR block 650 may be filtered via an RC circuit comprising a resistor 652 and a capacitor 654 in order to determine whether such signal provided as output by the logic XOR block 650 has a duration of its high logic level that is above a certain threshold.

The signal provided as output by the filtering stage RC is provided as input to an inverter 656 (for instance, a CMOS buffer).

Such inverter 656 is configured to provide as output a short circuit detection signal SD indicating either the presence of a short circuit if the signal provided as output by the filtering stage indicates that such duration is above such certain threshold or the absence of a short circuit if such signal provided as output by the filtering stage indicates that the duration is below the certain threshold.

Therefore, both in embodiments according to Figure 14 or Figure 12A, 12B, and 12C, that is, in embodiments that use AD modulation, and in embodiments according to Figure 13 related to the use of BD modulation, the checking operation used for verifying the presence of current unbalances between measures related to a high-side switch of a branch of the full-bridge and measures related to the low-side switch of the other branch of such full-bridge may be done by considering the delay of the rising of the voltage output provided by the first node $Out_P$ versus the falling of the voltage output provided by the second node $Out_M$, or vice versa, $Out_P$ falling versus $Out_M$ rising as described above.

Output nodes $Out_P$ and $Out_M$ do not usually output logic signals (both for voltage rail belonging and for non-regular fronts), thus their outputs are to be converted into logic signals, for instance, by using voltage comparators $Cmp_1$ and $Cmp_2$, having a threshold equal to, for instance, VCC/2 as described above.

For instance, in embodiments related to BD modulation and according to the exemplary implementation of Figure 13, the presence of unbalances may be checked by comparing the output signals provided by the output nodes $Out_P$ and $Out_M$ of the full-bridge class-D amplifier with a voltage reference threshold, for instance, having a value equal to VCC/2, obtaining two logic signals representing the timing behavior of such output signals provided by the nodes $Out_P$ and $Out_M$.

These two logic signals are provided as output by the comparators $Cmp_1$ and $Cmp_2$ and are sent to the logic unit 602 to generate the logic pulse signals Pls_r_M, Pls_f_P, Pls_r_P, and Pls_f_M indicative of respective time delays $T_{d\_r\_M}$, $T_{d\_f\_P}$, $T_{d\_r\_P}$, and $T_{d\_f\_M}$, for instance, having a width equal to such respective time delays.

Such logic pulse signals, in order to be compared asynchronously, are to be converted into voltage levels by charging and then discharging a capacitor C according to the first and the second implementations described above.

For instance, in embodiments related to AD modulation and according to the exemplary implementation of Figure 14, the presence of unbalances may be checked by:

directly coupling the outputs of the comparators $Cmp_1$ and $Cmp_2$ to the logic XOR block 650 described above; and

determining the presence of an unbalance if the resulting logic output provided by the logic XOR block 650 has a duration that is above a certain value. To verify whether such duration is above the certain value, it is possible to use an RC circuit 652 and 654 followed by an inverter 656.

Therefore, in circuits according to solutions as described herein, a first measure and a second measure may be time-based measurements obtained from a voltage-based measurement, preferably performed via fast comparators $Cmp_1$ and $Cmp_2$.

It is noted that such comparators $Cmp_1$ and $Cmp_2$ are to be designed to have a time response to the rising fronts TC_rise and a time response to the falling fronts TC_fall such that:

the value of the time response to the rising fronts TC_rise and the value of the time response to the falling fronts TC_fall, and
the difference between such value of the time response to the rising fronts TC_rise and such value of the time response to the falling fronts TC_fall,
are comprised within the pulse width resolution Tres of the output signals $Out_P$ or $Out_M$ (such pulse width resolution Tres being usually around 1ns - "nanoseconds").

In addition, such comparators $Cmp_1$ and $Cmp_2$ are to be well matched, for instance, having a time response difference smaller than such pulse width resolution Tres.

Instead, in embodiments according to Figure 14, the checking unit may be configured to check for the presence of unbalance between such first measure and such second measure by verifying, preferably via a logic XOR operator 650 and an RC filtering stage comprising a resistor 652 and a capacitor 654 and coupled to an inverter 656, whether one logic signal among:

a first logic signal indicative of a time behaviour of the output signal provided, via the node $Out_P$ or $Out_M$, by the high-side switch HP or HM comprised in one of the first branch and the second branch of the full-bridge class-D amplifier 5, preferably obtained via the first comparator $Cmp_1$ having a reference voltage threshold equal to half the supply voltage VCC, such first logic signal being indicative of one of the first measure and the second measure, and
a second logic signal indicative of a time behaviour of the output signal provided, via the node $Out_M$ or $Out_P$ respectively, by the low-side switch LM or LP, comprised in the other of the first branch and the second branch of the full-bridge class-D amplifier 5, preferably obtained via the second comparator $Cmp_2$ having a reference voltage threshold equal to half the supply voltage VCC, such second logic signal being indicative of the other of the first measure and the second measure,
assumes a certain logic level, for instance, a high logic level, for a duration higher than a duration threshold; and
by determining the presence of unbalance if the verifying operation indicates that either the first logic signal or the second logic signal assumes such certain logic level, for instance, a high logic level, for a duration higher than such duration threshold.

It is noted that in case of non-negligible asymmetries in the dynamic behavior of a low-side switch and a high-side switch of the full-bridge, such asymmetries resulting in a rising edge of a PWM signal provided as output by the full-bridge being delayed with respect to a falling edge of the other PWM signal provided as output by the full-bridge during normal driving conditions (that is, in absence of short circuits), it is possible to detect the short circuit by considering the happening of two consecutive pulses of the output buffer, that is, the happening of two consecutive short circuit presence indications of the short circuit detection signal SD.

Therefore, it is noted that also by using the described further approach (or the voltage-based approach described in Figures 13 and 14) it is possible to detect short circuits before the reaching of the maximum current allowed to flow in the switches of the full-bridge, thus, before that the full-bridge output stage is brought to operate close to non-safe operative conditions, detecting short circuits faster than known solutions.

In view of the above, it is noted that solutions as described herein facilitate the detection of short circuit conditions using asymmetries of the dynamic variables of full-bridge class-D amplifiers, that is, current, voltage, and time delays, caused by the presence of short circuits.

Solutions as described herein facilitate obtaining a circuit for detecting electrical short circuits, for instance, short circuit events to ground $Sh_{GND}$, to the supply voltage $Sh_{VCC}$, or to the battery voltage (if different from the supply voltage VCC), in a full-bridge class-D amplifier such as the full-bridge class-D amplifier 5 illustrated in Figure 1, such full-bridge class-D amplifier 5 comprising:

> a first branch comprising a first high-side switch HP configured to be coupled between a supply voltage VCC and a first output node $Out_P$ and a first low-side switch LP configured to be coupled between such first output node $Out_P$ and ground GND; and
> a second branch comprising a second high-side switch HM configured to be coupled between such supply voltage VCC and a second output node $Out_M$ and a second low-side switch LM configured to be coupled between such second output node $Out_M$ and ground GND.

The circuit according to solutions as described herein comprises:

> a measuring unit (for instance, the current sensors $I_{sens}$, the logic unit 602 and the storing unit 604, or the components 650-654 of Figure 14) configured to provide: a first measure of a first operating characteristic (for instance, a current, a voltage, or a time measure) of the high-side switch (for instance, HP or HM) comprised in one of the first branch and the second branch of the full-bridge class-D amplifier 5; and a second measure of a second operating characteristic (for instance, again a current, a voltage, or a time measure) of the low-side switch (for instance, LM or LP respectively) comprised in the other of the first branch and the second branch of the full-bridge class-D amplifier 5;
> a checking unit (for instance, the control logic unit CL, the comparison unit 606, or the inverter 656) configured to receive from the measuring unit the first measure and the second measure and to provide an unbalance signal, for instance, the short detection signal SD, indicative of the presence of unbalance between such first measure and such second measure; and
> a detection unit configured to receive from the checking unit such unbalance signal SD and to detect the presence of an electrical short circuit in response to such unbalance signal SD indicating the presence of unbalance between such first measure and such second measure.

In addition, the checking unit of a circuit according to solutions as described herein may be configured to check for the presence of unbalance between such first measure and such second measure by:

> determining an absolute value of a difference between such first measure and such second measure;
> checking whether such absolute value of the difference is higher than a threshold, for instance, a current, a voltage, or a time threshold; and
> determining the presence of unbalance if the checking operation indicates that such absolute value of the difference is higher than such threshold.

Thus, solutions as described herein facilitate providing reliable short circuit detection and protection features even in presence of supply voltages having high values, for instance, supply voltages above 14.4V, hence, improving safety and preventing dangerous or faulty conditions due to the presence of such short circuits, improving the robustness of full-bridge class-D amplifiers to short circuits to the supply voltage VCC, to ground GND, or to a battery voltage (if different from the supply voltage VCC).

In addition, solutions as described herein facilitate discriminating in a (even very) short time, for instance, in few periods of a PWM ("Pulse-Width Modulation") signal used to drive a full-bridge class-D amplifier, the presence of a short circuit to ground GND or to the supply voltage VCC with respect to the normal driving conditions.

The detection of the presence of a short circuit described in the above is performed independently from the value of an output current $I_{out}$ provided by the full-bridge class-D amplifier to a load LD coupled therewith, that is, independently from the value of the output current $I_{out}$ with respect to a maximum current allowed to flow in the switches of the full-bridge.

In this regard, the short circuit can be detected also in presence of output current $I_{out}$ values that are lower than the maximum current allowed to flow in transistors of the full-bridge class-D amplifier that is usually considered as a threshold for enabling the over-current protections ("OCP").

Therefore, in solutions according to the present description, more time is available for enabling the short circuit protection measures (that is, the OCP) before that the full-bridge output stage enters in non-safe operative conditions.

In fact, in every one of the approaches described above, it is possible to detect short circuits before the reaching of the maximum current allowed to flow in the switches of the full-bridge, thus, before that the full-bridge output stage is brought to operate close to non-safe operative conditions, hence, the detection of short circuits is faster.

It is noted that solutions as described herein also refers to a method of detecting electrical short circuits, for instance, short circuit events to ground $Sh_{GND}$, to the supply voltage $Sh_{VCC}$, or to the battery voltage (if different from the supply voltage VCC), in a full-bridge class-D amplifier such as the full-bridge class-D amplifier 5 illustrated in Figure 1.

The full-bridge class-D amplifier 5 comprises:

a first branch comprising a first high-side switch HP configured to be coupled between a supply voltage VCC and a first output node $Out_P$ and a first low-side switch LP configured to be coupled between such first output node $Out_P$ and ground GND; and a second branch comprising a second high-side switch HM configured to be coupled between such supply voltage VCC and a second output node $Out_M$ and a second low-side switch LM configured to be coupled between such second output node $Out_M$ and ground GND.

The method according to solutions as described herein comprises:

providing, via a measuring unit (for instance, the current sensors $I_{sens}$, the logic unit 602 and the storing unit 604, or the components 650-654 of Figure 14): a first measure of a first operating characteristic (for instance, a current, a voltage, or a time measure) of the high-side switch HP or HM comprised in one of the first branch and the second branch of the full-bridge class-D amplifier 5; and a second measure of a second operating characteristic (for instance, again a current, a voltage, or a time measure) of the low-side switch LM or LP comprised in the other of the first branch and the second branch of the full-bridge class-D amplifier 5;

receiving, at a checking unit (for instance, the control logic unit CL, the comparison unit 606, or the inverter 656), the first measure and the second measure from the measuring unit;

providing, via the checking unit, an unbalance signal indicative of the presence of unbalance between such first measure and such second measure, for instance, the short detection signal SD described above;

receiving, at a detection unit, such unbalance signal SD from the checking unit; and

detecting, via the detection unit, the presence of an electrical short circuit in response to such unbalance signal SD being indicative of the presence of unbalance between such first measure and such second measure.

In addition, the method according to solutions as described herein may comprise checking, via the checking unit, for the presence of unbalance between the first measure and the second measure by:

determining an absolute value of a difference between the first measure and the second measure;

checking whether the absolute value of the difference is higher than a threshold, for instance, a current, a voltage, or a time threshold; and

determining the presence of unbalance if the checking operation indicates that the absolute value of the difference is higher than such threshold.

It is also noted that the method according to the present description may further comprise any other step to implement the operations performed by the circuit according to the description above.

Without prejudice to the underlying principles, the details and the embodiments may vary, even significantly, with respect to what has been described by way of example only without departing from the scope of the embodiments.

The extent of protection is determined by the annexed claims.

**Claims**

1. A circuit (15; 30; 60; 65) for detecting electrical short circuits ($Sh_{VCC}$; $Sh_{GND}$) in a full-bridge class-D amplifier (5), the full-bridge class-D amplifier (5) comprising:

a first branch (HP, LP) comprising a first high-side switch (HP) configured to be coupled between a supply voltage (VCC) and a first output node ($Out_P$) and a first low-side switch (LP) configured to be coupled between said first output node ($Out_P$) and ground (GND); and a second branch (HM, LM) comprising a second high-side switch (HM) configured to be coupled between said supply voltage (VCC) and a second output node ($Out_M$) and a second low-side switch (LM) configured to be coupled between said second output node ($Out_M$) and ground (GND);

the circuit (15; 30; 60; 65) comprising:

a measuring unit ($I_{sens}$; 602-604; 650-654) configured to provide a first measure of a first operating characteristic of the high-side switch (HP; HM) comprised in one of the first branch (HP, LP) and the second branch (HM, LM) of the full-bridge class-D amplifier (5), and a second measure of a second operating characteristic of the low-side switch (LM; LP) comprised in the other of the first branch (HP, LP) and the second branch (HM, LM) of the full-bridge class-D amplifier (5);

a checking unit (CL; 606; 656) configured to receive from the measuring unit ($I_{sens}$; 602-604; 650-654) the first measure and the second measure and to provide an unbalance signal (SD) indicative of the presence of unbalance between said first measure and said second measure; and

a detection unit configured to receive from the checking unit (CL; 606; 656) said unbalance signal (SD) and to detect the presence of an electrical short circuit in response to said unbalance signal (SD) indicating the presence of unbalance between said first measure and said second measure.

2. The circuit (15; 30; 60; 65) according to claim 1, wherein said checking unit (CL; 606; 656) is configured to check for the presence of unbalance between said first measure and said second measure by:

determining an absolute value of a difference between said first measure and said second measure;

checking whether said absolute value of the difference is higher than a threshold; and

determining the presence of unbalance if the checking operation indicates that said absolute value of the difference is higher than said threshold.

3. The circuit (15; 30) according to claim 1 or claim 2, wherein said first measure and said second measure are current-based measures, wherein:

said first measure is indicative of a current ($I_{sensHP}$; $I_{sensHM}$; $I_{sensP}$; $I_{sensM}$) flowing in the high-side switch (HP; HM) comprised in one of the first branch (HP, LP) and the second branch (HM, LM) of the full-bridge class-D amplifier (5); and

said second measure is indicative of a current ($I_{sensLP}$; $I_{sensLM}$; $I_{sensP}$; $I_{sensM}$) flowing in the low-side switch (LM; LP) comprised in the other of the first branch (HP, LP) and the second branch (HM, LM) of the full-bridge class-D amplifier (5).

4. The circuit (15) according to claim 3, wherein said measuring unit ($I_{sens}$) comprises:

a first current sensor ($I_{sensHP}$) coupled to the first high-side switch (HP) and configured to sense a current flowing therein,

a second current sensor ($I_{sensHM}$) coupled to the second high-side switch (HM) and configured to sense a current flowing therein,

a third current sensor ($I_{sensLP}$) coupled to the first low-side switch (LP) and configured to sense a current flowing therein, and

a fourth current sensor ($I_{sensLM}$) coupled to the second low-side switch (LM) and configured to sense a current flowing therein,

and wherein said first measure is detected either via the first current sensor ($I_{sensHP}$) or the second current sensor ($I_{sensHM}$) and said second measure is detected either via the fourth current sensor ($I_{sensLM}$) or the third current sensor ($I_{sensLP}$), respectively;

or

wherein said measuring unit ($I_{sens}$) comprises:

a high-side current sensor ($I_{sensHP}$; $I_{sensHM}$) configured to be coupled either to the first high-side switch (HP) or the second high-side switch (HM) and to sense a current flowing in the coupled high-side switch, and

a low-side current sensor ($I_{sensLP}$; $I_{sensLM}$) configured to be coupled either to the second low-side switch (LM) or the first low-side switch (LP) respectively, and to sense a current flowing in the coupled low-side switch,

and wherein said first measure is detected via the high-side current sensor ($I_{sensHP}$; $I_{sensHM}$) and said second measure is detected via the low-side current sensor ($I_{sensLP}$; $I_{sensLM}$).

5. The circuit (15) according to claim 4, wherein said current sensors ($I_{sensHP}$; $I_{sensHM}$; $I_{sensLP}$; $I_{sensLM}$) comprise a, preferably flash, Analog-to-Digital Converter, ADC, (200) configured:

to sense a voltage ($V_{sens}$) proportional to the current flowing in the respective switch coupled to the current sensor;

to sense a reference voltage ($V_{ref}$) proportional to a maximum acceptable current ($I_{ref}$) flowing in a reference switch ($L_{ref}$) matched with said respective switch; and
to convert said sensed voltage ($V_{sens}$) in a digital value based on said sensed reference voltage ($V_{ref}$), said digital value being the first measure or the second measure.

6. The circuit (25) according to claim 3, wherein said measuring unit ($I_{sens}$) comprises a level-shifter (250) configured:

to sense one voltage out of a voltage ($V_{sensP}$) proportional to the current flowing in the high-side switch (HP; HM) comprised in one of the first branch (HP, LP) and the second branch (HM, LM) of the full-bridge class-D amplifier (5) and a voltage ($V_{sensM}$) proportional to the current flowing in the low-side switch (LM; LP) comprised in the other of the first branch (HP, LP) and the second branch (HM, LM) of the full-bridge class-D amplifier (5),
to level-shift said sensed voltage ($V_{sensP}$; $V_{sensM}$) to a voltage level of the other voltage out of the voltage ($V_{sensP}$) proportional to the current flowing in the high-side switch (HP; HM) comprised in one of the first branch (HP, LP) and the second branch (HM, LM) of the full-bridge class-D amplifier (5) and the voltage ($V_{sensM}$) proportional to the current flowing in the low-side switch (LM; LP) comprised in the other of the first branch (HP, LP) and the second branch (HM, LM) of the full-bridge class-D amplifier (5),
to provide said level-shifted sensed voltage as said first measure in response to the sensed voltage ($V_{sensP}$; $V_{sensM}$) being the voltage ($V_{sensP}$) proportional to the current flowing in the high-side switch (HP; HM) comprised in one of the first branch (HP, LP) and the second branch (HM, LM) of the full-bridge class-D amplifier (5), the voltage ($V_{sensM}$) proportional to the current flowing in the low-side switch (LM; LP) comprised in the other of the first branch (HP, LP) and the second branch (HM, LM) of the full-bridge class-D amplifier (5) being provided as the second measure, and
to provide the voltage ($V_{sensP}$) proportional to the current flowing in the high-side switch (HP; HM) comprised in one of the first branch (HP, LP) and the second branch (HM, LM) of the full-bridge class-D amplifier (5) as the first measure in response to the sensed voltage ($V_{sensP}$; $V_{sensM}$) being the voltage ($V_{sensM}$) proportional to the current flowing in the low-side switch (LM; LP) comprised in the other of the first branch (HP, LP) and the second branch (HM, LM) of the full-bridge class-D amplifier (5), said level-shifted sensed voltage being provided as the second measure.

7. The circuit (25) according to claim 3, wherein said measuring unit ($I_{sens}$) comprises:
a first level-shifter configured:

to sense a voltage ($V_{sensP}$) proportional to the current flowing in said high-side switch (HP; HM) comprised in one of the first branch (HP, LP) and the second branch (HM, LM) of the full-bridge class-D amplifier (5),
to level-shift said sensed voltage ($V_{sensP}$) to a voltage level, and
to provide said level-shifted sensed voltage as said first measure; and
a second level-shifter configured:

to sense a voltage ($V_{sensM}$) proportional to the current flowing in said low-side switch (LM; LP) comprised in the other of the first branch (HP, LP) and the second branch (HM, LM) of the full-bridge class-D amplifier (5),
to level-shift said sensed voltage ($V_{sensM}$) to said voltage level, and
to provide said level-shifted sensed voltage as said second measure.

8. The circuit (30) according to claim 3, wherein said measuring unit ($I_{sens}$) comprises:

a first branch current sensor ($I_{sensP}$) coupled to the first output node ($Out_P$) and configured to sense a current ($I_{outP}$) flowing therein, and
a second branch current sensor ($I_{sensM}$) coupled to the second output node ($Out_M$) and configured to sense a current ($I_{outM}$) flowing therein; and wherein said first measure is detected via one current sensor out of the first branch current sensor ($I_{sensP}$) and the second branch current sensor ($I_{sensM}$) and said second measure is detected via the other current sensor out of the first branch current sensor ($I_{sensP}$) and the second branch current sensor ($I_{sensM}$).

9. The circuit (30) according to claim 8, wherein said first branch current sensor ($I_{sensP}$) and said second branch current sensor ($I_{sensM}$) are implemented via shunt resistors, preferably by MOS parasitic metal resistance, metal sensing, or hall effect sensing.

10. The circuit (60; 65) according to claim 1 or claim 2, wherein said first measure and said second measure are time-based measures and wherein said first branch (HP, LP) and said second branch (HM, LM) of the full-bridge class-D amplifier (5; 35) are driven via respective drivers (102) configured to receive respective driving signals ($D_{INP}$; $D_{INM}$); wherein:

said first measure is indicative of a time delay ($T_{d\_r\_P}$; $T_{d\_r\_M}$) from a rising edge of a driving signal ($D_{INP}$; $D_{INM}$) provided to a driver ($102_{HP}$; $102_{HM}$) configured to drive said high-side switch (HP; HM) comprised in one of the first branch (HP, LP) and the second branch (HM, LM) of the full-bridge class-D amplifier (5) to a corresponding rising edge of an output signal ($I_{outP}$, $Out_P$; $I_{outM}$, $Out_M$) provided by said high-side switch (HP; HM); and

said second measure is indicative of a time delay ($T_{d\_f\_P}$; $T_{d\_f\_M}$) from a falling edge of a driving signal ($D_{INP}$; $D_{INM}$) provided to a driver ($102_{LP}$; $102_{LM}$) configured to drive said low-side switch (LM; LP) comprised in the other of the first branch (HP, LP) and the second branch (HM, LM) of the full-bridge class-D amplifier (5) to a corresponding falling edge of an output signal ($I_{outP}$, $Out_P$; $I_{outM}$, $Out_M$) provided by said low-side switch (LM; LP).

11. The circuit (60) according to claim 10, wherein said measuring unit (602-604) comprises:

a first storing unit (604; C) configured to store said first measure, and
a second storing unit (604; C) configured to store said second measure,
and wherein said checking unit (606) is configured to receive the first measure and the second measure from said first storing unit and said second storing unit comprised in the measuring unit (602-604), respectively;
wherein, preferably:

the first storing unit (604; C) is a first capacitor configured to store a voltage indicative of the first measure,
the second storing unit (604; C) is a second capacitor configured to store a voltage indicative of the second measure, and
said checking unit (606) is configured to receive the voltage indicative of the first measure and the voltage indicative of the second measure from said first storing unit and said second storing unit comprised in the measuring unit (602-604), respectively.

12. The circuit (60) according to claim 10 or claim 11 in combination with claim 2, wherein said operation of determining the absolute value of the difference between said first measure and said second measure comprises:

pre-charging a capacitor (C) to a reference voltage, preferably having a value equal to half the supply voltage (VCC), via a reference current ($I_x$);

charging said capacitor (C) with said reference current ($I_x$), increasing a capacitor voltage of a first voltage indicative of the first measure;
discharging said capacitor (C) with said reference current ($I_x$), decreasing said capacitor voltage of a second voltage indicative of the second measure; and
providing a first capacitor voltage equal to said capacitor voltage plus a margin and a second capacitor voltage equal to said capacitor voltage minus said margin as the absolute value of the difference between said first measure and said second measure;
and wherein said operation of checking whether said absolute value of the difference is higher than a threshold comprises checking (608) whether said first capacitor voltage is lower than said voltage reference or said second capacitor voltage is higher than said voltage reference.

13. The circuit (65) according to claim 12, wherein said first voltage indicative of the first measure is obtained by:

converting the output signal ($Out_P$; $Out_M$) provided by the high-side switch (HP; HM) comprised in one of the first branch (HP, LP) and the second branch (HM, LM) of the full-bridge class-D amplifier (5) in a first logic signal indicative of a time behaviour of said output signal ($Out_P$; $Out_M$), preferably via a first comparator ($Cmp_1$) having a reference voltage threshold equal to half the supply voltage (VCC); and
converting (602; 604) said first logic signal in said first voltage indicative of the first measure, preferably by charging a first capacitor (C) based on said first logic signal;
and wherein said second voltage indicative of the second measure is obtained by:

converting the output signal ($Out_P$; $Out_M$) provided by the low-side switch (LM; LP) comprised in the other of the first branch (HP, LP) and the second branch (HM, LM) of the full-bridge class-D amplifier (5) in a second logic signal indicative of a time behaviour of said output signal ($Out_P$; $Out_M$), preferably via a second comparator ($Cmp_2$) having a reference voltage threshold equal to half the supply voltage (VCC); and
converting (602; 604) said second logic signal in said second voltage indicative of the second measure, preferably by charging a second capacitor (C) based on said second logic signal.

14. The circuit (65) according to claim 10 in combination with claim 1, wherein said checking unit is configured to check for the presence of unbalance between said first measure and said second measure by verifying, preferably via a logic XOR operator (650) and via an RC filtering stage (652; 654) coupled to an inverter (656), whether one logic signal among:

a first logic signal indicative of a time behaviour of the output signal ($Out_P$; $Out_M$) provided by the high-side switch (HP; HM) comprised in one of the first branch (HP, LP) and the second branch (HM, LM) of the full-bridge class-D amplifier (5), preferably obtained via a first comparator ($Cmp_1$) having a reference voltage threshold equal to half the supply voltage (VCC), said first logic signal being indicative of one of the first measure and the second measure, and

a second logic signal indicative of a time behaviour of the output signal ($Out_P$; $Out_M$) provided by the low-side switch (LM; LP) comprised in the other of the first branch (HP, LP) and the second branch (HM, LM) of the full-bridge class-D amplifier (5), preferably obtained via a second comparator ($Cmp_2$) having a reference voltage threshold equal to half the supply voltage (VCC), said second logic signal being indicative of the other of the first measure and the second measure,

assumes a logic level, preferably a high logic level, for a duration higher than a duration threshold; and

determining the presence of unbalance if the verifying operation (650-656) indicates that one logic signal among the first logic signal and the second logic signal assumes said logic level, preferably a high logic level, for a duration higher than said duration threshold.

15. A method of detecting electrical short circuits ($Sh_{VCC}$; $Sh_{GND}$) in a full-bridge class-D amplifier (5), the full-bridge class-D amplifier (5) comprising:

a first branch (HP, LP) comprising a first high-side switch (HP) configured to be coupled between a supply voltage (VCC) and a first output node ($Out_P$) and a first low-side switch (LP) configured to be coupled between said first output node ($Out_P$) and ground (GND); and

a second branch (HM, LM) comprising a second high-side switch (HM) configured to be coupled between said supply voltage (VCC) and a second output node ($Out_M$) and a second low-side switch (LM) configured to be coupled between said second output node ($Out_M$) and ground (GND);

the method comprising:

providing, via a measuring unit ($I_{sens}$;

602-604; 650-654), a first measure of a first operating characteristic of the high-side switch (HP; HM) comprised in one of the first branch (HP, LP) and the second branch (HM, LM) of the full-bridge class-D amplifier (5), and a second measure of a second operating characteristic of the low-side switch (LM; LP) comprised in the other of the first branch (HP, LP) and the second branch (HM, LM) of the full-bridge class-D amplifier (5);

receiving, at a checking unit (CL; 606; 656), the first measure and the second measure from the measuring unit ($I_{sens}$; 602-604; 650-654);

providing, via the checking unit (CL; 606; 656), an unbalance signal (SD) indicative of the presence of unbalance between said first measure and said second measure;

receiving, at a detection unit, said unbalance signal (SD) from the checking unit (CL; 606; 656); and

detecting, via the detection unit, the presence of an electrical short circuit in response to said unbalance signal (SD) being indicative of the presence of unbalance between said first measure and said second measure.

FIG. 1

FIG. 2

15

HM

VCC

LM

Out$_M$

GND

$I_{sensHM}$

$I_{sensLM}$

CL

$I_{sensHP}$

$I_{sensLP}$

VCC

Out$_P$

GND

HP

LP

FIG. 3

FIG. 4

FIG. 5

FIG. 6

EP 4 757 177 A1

EP 4 757 177 A1

$I_{sensP}; I_{sensM}$

RS

$I_{outP}; I_{outM}$

300

$KI_{out}$

FIG. 7A

$I_{sensP}; I_{sensM}$

$I_{outP}; I_{outM}$

302

304

$KI_{out}$

FIG. 7B

FIG. 8

FIG. 9

EP 4 757 177 A1

FIG. 10A

EP 4 757 177 A1

FIG. 10B

EP 4 757 177 A1

FIG. 11A

FIG. 11B

EP 4 757 177 A1

FIG. 12A

FIG. 12B

FIG. 12C

FIG. 13

EP 4 757 177 A1

FIG. 14

EP 4 757 177 A1

| | Europäisches Patentamt / European Patent Office / Office européen des brevets | **EUROPEAN SEARCH REPORT** | **Application Number** EP 25 22 0823 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/086577 A1 (RAMAMURTHY VENKATA RAMANAN [IN] ET AL) 17 March 2022 (2022-03-17) | 1-9,15 | INV. H03F3/217 H03F1/52 |
| A | * paragraphs [0002] - [0053]; figures 1-6 * | 10-14 | H03F3/187 G01R31/52 |
| A | US 2018/076781 A1 (KOYAMA YASUYUKI [JP]) 15 March 2018 (2018-03-15) * paragraphs [0002] - [0083]; figures 1-8 * | 1-15 | |
| A | US 2017/160316 A1 (BOTTI EDOARDO [IT] ET AL) 8 June 2017 (2017-06-08) * paragraphs [0002] - [0084]; figures 1-12 * | 1-15 | |
| A | US 2020/287507 A1 (DU RU FENG [CN] ET AL) 10 September 2020 (2020-09-10) * paragraphs [0002] - [0087]; figures 1-6 * | 1-15 | |

TECHNICAL FIELDS SEARCHED (IPC)

H03F
G01R

The present search report has been drawn up for all claims

| Place of search | Date of completion of the search | Examiner |
|---|---|---|
| The Hague | 31 March 2026 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 0823

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2026

| Patent document cited in search report | | Publication date | Patent family member(s) | | Publication date |
|---|---|---|---|---|---|
| US 2022086577 | A1 | 17-03-2022 | CN | 116057396 A | 02-05-2023 |
| | | | US | 2022086577 A1 | 17-03-2022 |
| | | | WO | 2022061051 A1 | 24-03-2022 |
| US 2018076781 | A1 | 15-03-2018 | CN | 107834985 A | 23-03-2018 |
| | | | JP | 6820171 B2 | 27-01-2021 |
| | | | JP | 2018046431 A | 22-03-2018 |
| | | | US | 2018076781 A1 | 15-03-2018 |
| US 2017160316 | A1 | 08-06-2017 | CN | 106851474 A | 13-06-2017 |
| | | | CN | 205961068 U | 15-02-2017 |
| | | | EP | 3179631 A1 | 14-06-2017 |
| | | | US | 2017160316 A1 | 08-06-2017 |
| US 2020287507 | A1 | 10-09-2020 | CN | 111654252 A | 11-09-2020 |
| | | | CN | 211557236 U | 22-09-2020 |
| | | | EP | 3706313 A1 | 09-09-2020 |
| | | | US | 2020287507 A1 | 10-09-2020 |

EPO FORM P0459

For more details about this annex : see Official Journal of the European Patent Office, No. 12/82